# EUROPÄISCHE PATENTSCHRIFT

(11) **EP 3 468 317 B1**
(45) Veröffentlichungstag und Bekanntmachung des Hinweises auf die Patenterteilung: **03.09.2025**
(21) Anmeldenummer: 18198723.1
(22) Anmeldetag: 04.10.2018
(51) Int. Cl.: H05K 3/00, H05K 3/46, H05K 1/02, H05K 1/16, H05K 1/18, H05K 3/10, H05K 3/40

(54) **KOMPONENTENTRÄGER MIT ZUMINDEST EINEM TEIL AUSGEBILDET ALS DREIDIMENSIONAL GEDRUCKTE STRUKTUR**
COMPONENT CARRIER WITH AT LEAST ONE PORTION IN THE FORM OF THREE-DIMENSIONALLY PRINTED STRUCTURE
SUPPORT DE COMPOSANT DOTÉ D'AU MOINS UNE PARTIE CONÇUE SOUS LA FORME DE STRUCTURE IMPRIMÉE TRIDIMENSIONNELLE

(30) Priorität: 06.10.2017 DE 102017123307
(43) Veröffentlichungstag der Anmeldung: 10.04.2019
(73) Patentinhaber: AT & S Austria Technologie & Systemtechnik Aktiengesellschaft, 8700 Leoben (AT)
(72) Erfinder: Gavagnin, Marco, 8700 Leoben (AT); Silvano De Sousa, Jonathan, 1100 Wien (AT); Leitgeb, Markus, 8793 Trofaiach (AT); Moitzi, Heinz, 8740 Zeltweg (AT); Krivec, Thomas, 8740 Zeltweg (AT); Grober, Gernot, 8045 Graz (AT); Schlaffer, Erich, 8642 St. Lorenzen (AT); Morianz, Mike, 8045 Graz (AT); Frauwallner, Rainer, 8612 Tragöss (AT); Haidinger, Hubert, 8321 Sankt Margarethen an der Raab (AT); Schulz, Gernot, 8020 Graz (AT); Gmundner, Gernot, 8605 Parschlug (AT); Lutschounig, Ferdinand, 9170 Ferlach (AT)
(74) Vertreter: Dilg, Haeusler, Schindelmann Patentanwaltsgesellschaft mbH

(56) Entgegenhaltungen:
- EP-A1- 2 706 559
- EP-A1- 3 151 641
- EP-A1- 3 199 266
- WO-A1-2010/125924
- WO-A1-2013/010108
- WO-A1-2015/073992
- WO-A1-2015/161971
- WO-A1-2016/134167
- WO-A1-2016/140909
- WO-A1-2016/185215
- WO-A2-2014/209994
- WO-A2-2016/007207
- US-A1- 2015 104 562
- US-A1- 2015 201 500
- US-A1- 2016 278 200
- US-A1- 2017 013 712
- US-A1- 2017 084 810
- US-A1- 2017 135 215
- US-A1- 2017 215 286
- US-A1- 2017 225 273
- US-A1- 2017 246 799
- US-A1- 2017 279 207

## Beschreibung

### Technisches Gebiet

Die Erfindung betrifft einen Komponententräger, wobei zumindest ein Teil des Komponententrägers als dreidimensionale Struktur ausgebildet ist. Ferner betrifft die Erfindung ein Verfahren zum Herstellen eines Komponententrägers, wobei zumindest ein Teil des Komponententrägers als dreidimensionale Struktur ausgebildet wird.

### Hintergrund der Erfindung

Konventionelle Komponententräger werden als einschichtige oder mehrschichtige Komponententräger hergestellt. Üblicherweise werden sie dabei photochemisch hergestellt, indem die elektrisch leitenden Schichten mittels eines Fotoresists laminiert werden. Nach der Belichtung des Fotoresists durch eine Maske, welche die gewünschte Struktur der elektrisch leitenden Schicht enthält, werden entweder die belichteten oder unbelichteten Anteile des Fotoresists in einer entsprechenden Lösung entfernt. Wichtig für die Qualität und die Funktionsweise des Komponententrägers sind zum einen die verwendeten Materialien und zum anderen die Aufbringung bzw. Verbindung der verwendeten Materialien untereinander. Durch die immer höher werdenden Anforderungen an die Komponententräger aufgrund der zunehmenden Miniaturisierung in der Elektrotechnik, erhöhen sich auch die Anforderung an die verwendeten Materialien und die Struktur des Komponententrägers selbst. Aus diesem Grund gibt es immer noch Raum für verbesserte Komponententräger und deren Herstellungsverfahren.

US 2015/0201500 A1 offenbart einen Komponententräger gemäß dem Oberbegriff von Anspruch 1.

US 2017/013712 A1 offenbart ein mehrschichtiges 3D-Druck-Laserdirektstrukturierungsverfahren und eine Vorrichtung für elektrische Verbindungen und Antennen. 3D-gedruckte Komponenten können mit strukturell integrierten Metallverbindungen (z. B. hochleitfähiges Metall in großen Mengen) konfiguriert werden, die mehrere Schichten (einige eingebettet und andere extern) einer Struktur durchqueren, die mit einem additiven Fertigungssystem hergestellt wurde, das durch iterative laseraktivierte Beschichtungsverfahren verbessert wurde. In der US 2015/104562 A1 wird ein vollständig additives Verfahren zur Herstellung mehrschichtiger elektrischer Verbindungen für gedruckte elektronische und/oder optoelektronische Geräte beschrieben. Elektrische Verbindungen werden durch direktes Tintenstrahldrucken eines dielektrischen Materials mit selektiven Verbindungslöchern hergestellt. Anschließend werden leitfähige Muster per Tintenstrahldruck aufgedruckt und die Verbindungslöcher mit leitfähigem Material gefüllt, um mehrschichtige Verbindungen herzustellen.

### Darstellung der Erfindung

Es ist eine Aufgabe der vorliegenden Erfindung einen Komponententräger bereitzustellen, welcher einfach herzustellen ist und mehr Flexibilität in der Anordnung der Komponententrägerstrukturen erlaubt.

Diese Aufgabe wird jeweils durch die Gegenstände mit den Merkmalen der Ansprüche 1 und 13 gelöst. Weitere Ausführungsbeispiele werden in den abhängigen Ansprüchen gezeigt.

Unter dem Begriff "Komponententräger" wird insbesondere jede Stützstruktur verstanden, welche fähig ist eines oder mehrere Komponenten darauf und/oder darin aufzunehmen zum Bereitstellen einer mechanischen Stütze und/oder elektrischen Verbindung. In anderen Worten, ein Komponententräger kann konfiguriert sein als ein mechanischer und/oder elektrischer Träger für Komponenten. Insbesondere, kann ein Komponententräger eines sein von einer Leiterplatte, einem organischen Interposer und einem IC (integriertem Schaltkreis) Substrat. Ein Komponententräger kann auch ein Hybridboard sein, welches die verschiedenen obengenannten Typen von Komponententrägern kombiniert.

Gemäß einer Ausführungsform der Erfindung, weist der Komponententräger einen Trägerkörper mit einem Stapel von zumindest einer elektrisch isolierenden Schichtstruktur und zumindest einer elektrisch leitenden Schichtstruktur auf. Zum Beispiel kann der Komponententräger ein Laminat aus den genannten elektrisch isolierenden Schichtstruktur(en) und den elektrisch leitenden Schichtstruktur(en) sein, welches insbesondere mittels Anwendens von mechanischem Druck geformt wird, wenn gewünscht unterstützt mittels thermischer Energie. Der genannte Stapel kann einen plattenförmigen Komponententräger bereitstellen, welcher fähig ist eine große Befestigungsoberfläche für weitere Komponenten bereitzustellen und welcher dennoch sehr dünn und kompakt ist. Unter dem Begriff "Schichtstruktur" wird insbesondere eine kontinuierliche Schicht, eine strukturierte Schicht oder eine Mehrzahl von nicht konsekutiven Inseln innerhalb einer gemeinsamen Ebene verstanden. Der Komponententräger weist einen Trägerkörper, auf welcher aus verschiedenen Schichtstrukturen besteht, d.h. aus elektrisch isolierenden und elektrisch leitenden Schichtstrukturen. Die verschiedenen Schichtstrukturen können so angeordnet sein, dass die Reihenfolge von der elektrisch isolierenden Schichtstruktur und der elektrisch leitenden Schichtstruktur wechselt. Zum Beispiel kann der Trägerkörper eine Schichtstruktur aufweisen, welche mit der elektrisch leitenden Schichtstruktur beginnt, welche von einer elektrisch isolierenden Schichtstruktur gefolgt wird und welche ferner von einer elektrisch leitenden Schichtstruktur gefolgt wird, sodass der Stapel des Komponententrägers ausgebildet wird.

Unter dem Begriff "zumindest ein Teil" des Komponententrägers wird insbesondere zumindest eine Schicht des Komponententrägers, elektrisch leitende Komponenten des Komponententrägers oder jegliche andere Teile welche den Komponententräger formen, verstanden. Das zumindest eine Teil kann ein leitendes Teil des Komponententrägers und/oder ein nicht leitendes und/oder isolierendes Teil von dem Komponententräger sein, bzw. auch eine Kombination davon. Ferner kann das zumindest eine Teil auf und/oder in zumindest einer der elektrisch leitenden Schichtstrukturen und/oder elektrisch isolierenden Schichtstrukturen geformt werden. Insbesondere kann auch der komplette Komponententräger als dreidimensional gedruckte Struktur ausgebildet werden.

Unter dem Begriff "dreidimensional gedruckte Struktur" wird insbesondere eine Struktur verstanden, welche mittels eines dreidimensionalen Druckprozesses hergestellt wird. Während des dreidimensionalen Druckprozesses werden die 3D gedruckten Strukturen Schicht für Schicht aufgebaut. Insbesondere wird unter dreidimensionalen Drucken ein Drucken mit pulverförmigem Material verstanden. Ein Prozess, welcher druckbares Material in Pulverform verwendet, ist das Selektive Laser Sintern (SLS) oder auch das Selektive Laser Schmelzen (SLM). Ein weiterer Prozess, welcher druckbare Materialien in Pulverform verwendet ist das Elektronenstrahl Schmelzen (EBM, oder auch Elektronenstrahl additive Fertigung EBAM). Unter 3D Drucken mit schmelzbaren Materialien kann insbesondere eine Fused Filament Fabrication (FFF) oder Fused Deposition Modeling (FDM, Schmelzschichtung) verstanden werden. Während des 3D Druckprozesses wird die dreidimensional gedruckte Struktur Schicht für Schicht aufgebaut.

Das Ausbilden eines Teiles eines Komponententrägers unter Verwendung eines dreidimensionalen Druckprozesses kann das Herstellen des Komponententrägers vereinfachen. Ferner, kann das Design des einen Teiles des Komponententrägers in einfacher Weise an seine Funktion und/oder an seine Position auf dem Komponententräger angepasst werden, sodass das Design des Komponententrägers selbst einfach anpassbar ist. Das Verwenden des 3D Druckens kann mehr Präzision während des Formens des einen Teiles des Komponententrägers garantieren. Ferner ist ein Anordnen von verschiedenen Teilen auf dem Komponententrägers mittels des 3D Druckverfahrens mit einer hohen Präzision umsetzbar.

Es wird angemerkt, dass der Begriff "Schichtstrukturen" im Rahmen dieses Dokumentes repräsentativ für die Mehrzahl der elektrisch leitenden Schichtstrukturen und der elektrisch isolierenden Schichtstrukturen verwendet werden kann.

Gemäß einer exemplarischen Ausführungsform der Erfindung ist die dreidimensional gedruckte Struktur im Inneren und/oder an einer Oberfläche des Trägerkörpers geformt. Die dreidimensional gedruckte Struktur ist auf einer der Mehrzahl der Schichtstrukturen ausgebildet werden und optional in einer von der Mehrzahl von Schichtstrukturen ausgebildet. Ferner kann die dreidimensional gedruckte Struktur ein Teil von einer der Mehrzahl Schichtstrukturen sein. Weiterhin kann die dreidimensional gedruckte Struktur sich zumindest teilweise durch den Trägerkörper erstrecken, sodass sich die dreidimensional gedruckte Struktur durch eine von der Mehrzahl von Schichtstrukturen erstreckt.

Gemäß einer exemplarischen Ausführungsform ist die dreidimensional gedruckte Struktur entlang einer Stapelrichtung der Mehrzahl von Schichtstrukturen geformt. Die Mehrzahl von Schichtstrukturen des Komponententrägers können als Stapel, d.h. übereinander geschichtet, angeordnet sein können. Daher kann unter dem Begriff "Stapelrichtung" insbesondere die Richtung verstanden werden, entlang welcher die gestapelten Schichten übereinander gestapelt sind. Die Stapelrichtung kann somit eine Erstreckungsrichtung der dreidimensional gedruckten Struktur durch die Mehrzahl der Schichtstrukturen sein.

Gemäß einer exemplarischen Ausführungsform ist die dreidimensional gedruckte Struktur senkrecht zu einer Stapelrichtung der Mehrzahl von Schichtstrukturen geformt. Die senkrechte Erstreckung in Bezug auf die Stapelrichtung kann eine Erstreckungsrichtung der dreidimensional gedruckten Struktur entlang zumindest einer von der Mehrzahl von Schichtstrukturen sein.

Gemäß einer exemplarischen Ausführungsform weist die dreidimensional gedruckte Struktur unterschiedliche Querschnittsflächen auf, insbesondere in einer Stapelrichtung der Mehrzahl von Schichtstrukturen und/ oder senkrecht zu einer Stapelrichtung der Mehrzahl von Schichtstrukturen. Die dreidimensional gedruckte Struktur kann verschiedene Querschnittsflächen aufweisen in Richtung einer Ebene, welche sich parallel zu der Mehrzahl von Schichtstrukturen erstreckt und/oder die dreidimensional gedruckte Struktur kann verschiedene Querschnittsflächen aufweisen in Richtung einer Ebene, welche sich senkrecht zu der Mehrzahl von Schichtstrukturen erstreckt. Aus diesem Grund kann die dreidimensional gedruckte Struktur verschiedene Dicken in einer Ebene parallel und/oder senkrecht zu der Mehrzahl von Schichtstrukturen aufweisen. Mittels des 3D Druckens können verschiedene Dicken in einfacher Weise realisiert werden.

Gemäß einer exemplarischen Ausführungsform weist der Komponententräger einen umgebenden Komponententrägerbereich und einen umgebenen Komponententrägerbereich auf, der von dem umgebenden Komponententrägerbereich umgeben ist, wobei insbesondere zumindest ein Teil des umgebenden Komponententrägerbereich und/oder des umgebenen Komponententrägerbereich als weitere dreidimensional gedruckte Struktur ausbildbar ist. Mit anderen Worten kann die dreidimensional gedruckte Struktur in einem Komponententrägerbereich ausgebildet werden, welcher die dreidimensionale Struktur umgibt und/oder die dreidimensional gedruckte Struktur kann in einem Komponententrägerbereich ausgebildet werden, sodass die dreidimensionale Struktur einen anderen Komponententrägerbereich umgibt. Dabei ist, je nach dem in welchem Bereich die dreidimensional gedruckte Struktur angeordnet ist, der entsprechende andere Bereich auch als (d.h. als weitere) dreidimensional gedruckte Struktur ausgebildet. Insbesondere kann die dreidimensional gedruckte Struktur in einem Komponententräger eingebettet sein, sodass die dreidimensional gedruckte Struktur auf/in einem Komponententräger gebildet wird, welcher in eine anderen Komponententräger integrierbar ist, oder auch anders herum.

Gemäß einer exemplarischen Ausführungsform bildet die dreidimensional gedruckte Struktur zumindest teilweise die elektrisch leitfähigen Schichtstrukturen aus. Insbesondere kann die dreidimensional gedruckte Struktur zumindest teilweise eine von der Mehrzahl von Schichtstrukturen ausbilden. Somit kann der dreidimensional gedruckte eine Teil des Komponententrägers zumindest eine der Mehrzahl der Schichtstrukturen sein.

Gemäß einer exemplarischen Ausführungsform ist die dreidimensional gedruckte Struktur als eine starre und/oder flexible Struktur ausgebildet. Wenn die dreidimensionale gedruckte Struktur als eine starre Struktur ausgebildet ist, kann die dreidimensional gedruckte Struktur dazu verwendet werden, um zumindest einen Teil eines starren Trägerkörpers, insbesondere einer starre Leiterplatte, auszubilden. Wenn die dreidimensional gedruckte Struktur als eine flexible Struktur ausgebildet ist, kann die dreidimensional gedruckte Struktur dazu verwendet werden, um zumindest einen Teil eines flexiblen Trägerkörpers, insbesondere einer flexiblen Leiterplatte, auszubilden. In Abhängigkeit von dem verwendeten 3D druckbaren Material für die dreidimensional gedruckte Struktur weist die 3D gedruckte Struktur starre und/oder flexible Eigenschaften auf. Unter flexiblen Eigenschaften, bzw. flexiblen Trägerkörper, wird z.B. ein biegbares Material verstanden, so dass zumindest ein Teil des Trägerkörpers unter Belastung reversibel verformbar ist. Im Gegensatz dazu ist ein starrer Teil eines Trägerkörpers weniger und/oder gar nicht verformbar.

Gemäß einer exemplarischen Ausführungsform weist der Trägerkörper eine Ausnehmung auf, wobei die dreidimensional gedruckte Struktur innerhalb der Ausnehmung gedruckt wird. Unter dem Begriff "Ausnehmung" wird insbesondere eine Kavität innerhalb des Trägerkörpers verstanden. Die Ausnehmung kann dabei so in dem Trägerkörper ausgebildet werden, dass die Ausnehmung zumindest von drei Seiten von dem Trägerkörper umgeben wird und somit durch die nicht umgebene Seite Kontakt zur Umgebung des Trägerkörpers hat. Auf der anderen Seite kann die Ausnehmung in dem Trägerköper derart ausgebildet sein, dass die Ausnehmung auf allen Seiten von dem Trägerkörper umschlossen ist und somit keinen Kontakt zur Umgebung des Trägerkörpers hat, d.h. nur Kontakt zu dem Trägerkörper selbst hat. Die Ausnehmung kann sich in Richtung einer Stapelrichtung des Trägerkörpers erstrecken und/oder die Ausnehmung kann sich senkrecht zu einer Stapelrichtung erstrecken. Ferner kann die dreidimensional gedruckte Struktur die Ausnehmung zumindest teilweise ausfüllen oder die dreidimensional gedruckte Struktur kann die Ausnehmung vollständig ausfüllen. Somit kann beispielsweise eine in dem Trägerkörper versenkbare Komponente dreidimensional eingedruckt werden.

Gemäß einer exemplarischen Ausführungsform ist die dreidimensional gedruckte Struktur zumindest teilweise als elektrisch leitendendes Verbindungselement, insbesondere als ein Anschlusspad, ein Pin, eine Buchse, ein Mikropin (oder auch Mikropillar), ein, insbesondere ringförmiger, Schleifkontakt und/oder ein Federkontakt ausgebildet. Ferner kann die 3D gedruckte Struktur ein lötbares Anschlusspad sein, welches direkt auf den Trägerkörper aufgedruckt wird. Ebenso kann die 3D gedruckte Struktur ein sich von dem Trägerkörper nach außen erstreckendes elektrisches Verbindungselement sein, so dass ein Pin, eine Buchse und/oder ein Mikropin gebildet wird mittels welcher elektronische Komponenten mit dem Trägerkörper verbunden werden können. Ferner kann die 3D gedruckte Struktur ein Schleifkontakt sein um somit eine nicht permanente Steckverbindung mit einer sehr hohen Lebensdauer und Zuverlässigkeit herzustellen. Das elektrisch leitende Verbindungselement kann auch eine Drahtverbindung, d.h. Leiterbahnverbindung, zwischen verschiedenen Komponenten des Trägerkörpers sein.

Gemäß einer exemplarischen Ausführungsform ist auf das leitende Verbindungselement ein Lötdepot aufbringbar, insbesondere als dreidimensional gedruckte Struktur. Somit kann ein Standard Lötprozess durch einen 3D Druck von Lot ersetzt werden. Das aufdruckbare Lot kann insbesondere Lötzinn sein. Das Drucken von Lot selbst ist von Vorteil, bei dem Drucken auf kupferfreie Elemente, wie Kupferschichten als elektrisch leitende Schicht, sodass ein direkter elektrisch leitender Kontakt zwischen den zwei verschiedenen Materialien hergestellt werden kann, sodass spezielle Flussmittel für den Lötprozess obsolet sind.

Gemäß einer exemplarischen Ausführungsform ist die dreidimensional gedruckte Struktur als ein Dämpfungselement, insbesondere als eine Feder, ausgebildet. Insbesondere ist die 3D gedruckte Struktur als eine Mikrofeder ausgebildet. Die Dämpfungselement(e) können direkt auf dem Trägerkörper aufgedruckt werden bzw. direkt auf eine der Mehrzahl von Schichtstrukturen. Damit kann eine zusätzliche Fertigung der Dämpfungselemente und ein anschließendes Verbinden der Dämpfungselemente an den Trägerkörper vermieden werden. Ferner werden somit integrierbare lösbare Dämpfungsverbindungen (oder auch Steckverbindungen) für die Montage von elektronischen Geräten geschaffen. Beispielsweise kann ein Dämpfungselement direkt auf Kupferplättchen des Trägerkörpers aufgedruckt werden mittels pulverbasiertem 3D Druckverfahren.

Gemäß einer exemplarischen Ausführungsform ist die dreidimensional gedruckte Struktur als ein mechanisches Verbindungselement, insbesondere eine Gewindebuchse, eine Schnappverbindung, eine Klettverbindung, eine Reißverschlussverbindung, eine Führungsschiene und/oder ein Führungspin, ausgebildet. Ist die 3D gedruckte Struktur als eine Gewindebuchse ausgebildet, stellt sie insbesondere ein mechanisches Depot für Schrauben dar und dient zur Schraubensicherung. Insbesondere ist das mechanische Verbindungselement ein spezielles Formelement als mechanisches Depot für Schrauben zur Aufnahme und Fixierung von Schraubverbindungen. Die mechanischen Verbindungen mittels des mechanischen Verbindungselementes können lösbar ausgebildet sein und/oder beweglich ausgebildet sein. Die Verbindungen können auch als elektrische Verbindungen fungieren, welche je nach Anforderung gelöst werden können. Zum Beispiel kann eine Reißverschlussverbindung teilweise elektrische Verbindungen aufweisen bzw. eingehen. Ferner ist es möglich, wenn das mechanische Verbindungselement eine Klettverbindung ist, dass mittels der Klettverbindung, welche an dem Trägerkörper ausgebildet, ist der Trägerkörper an Textilelementen oder einem anderen dazugehörigem Element, wie ein anderer Trägerkörper, PCB, Modul-Textilelement, Kleidung oder einer Hülle haftbar ist. Weiterhin kann das mechanische Verbindungelement als Ankerverbindung dienen, um den Trägerkörper an einer bestimmten Stelle in einer größeren Einheit zu halten.

Gemäß einer exemplarischen Ausführungsform ist das mechanische Verbindungselement eingerichtet eine lösbare Verbindung auszubilden. Die lösbare Verbindung kann dabei eine lösbare mechanische Verbindung und/oder eine lösbare teilweise elektrische Verbdingung sein.

Gemäß einer exemplarischen Ausführungsform bildet die dreidimensional gedruckte Struktur eine Verstärkungsstruktur aus, insbesondere eine Verstärkungsstruktur der elektrisch leitfähigen Schichtstrukturen Die Verstärkungsstruktur kann ferner zum Schutz von in den Trägerkörper eingebetteten Komponenten dienen, wobei die Verstärkungsstruktur um diese Komponenten angeordnet ist. Ferner kann die Verstärkungsstruktur um Ausnehmungen in zumindest einer der Mehrzahl von Schichtstrukturen angeordnet sein, um somit für Stabilität um diese Ausnehmungen zu sorgen.

Gemäß einer exemplarischen Ausführungsform ist die dreidimensional gedruckte Struktur eine wärmeleitende Struktur. Insbesondere dient die 3D gedruckte Struktur zur Wärmeableitung von wärmeerzeugenden Elementen, wie elektronischen Komponenten auf und/oder in dem Trägerkörper. Die wärmeleitende Struktur kann dabei insbesondere sein zumindest eines von einer Wärmesenke, Wärmerohr, einfache Kupferleitung zur Wärmeableitung oder ein Kühlblech. Die wärmeleitende Struktur kann in und oder auf dem Trägerkörper aufgedruckt werden. Als Material für die wärmeleitende Struktur können Kupfer oder auch wärmeleitende Keramiken verwendet werden.

Gemäß einer exemplarischen Ausführungsform bildet die dreidimensional gedruckte Struktur eine Oberfläche des Trägerkörpers aus, wobei Bereiche der Oberfläche sich in ihrer Härte, Rauigkeit und/oder Elastizität unterscheiden. Die dreidimensional gedruckte Struktur bildet die äußerste Schicht des Trägerkörpers aus, welche der Umgebung des Trägerkörpers ausgesetzt werden kann. Wird ein Teil des Trägerkörpers einer rauen Umgebung ausgesetzt, kann dieser Teil eine dreidimensional gedruckte Oberfläche mit einer hohen Härte aufweisen, um so den Teil des Trägerkörpers z.B. vor Abrieb und Schmutz zu schützen. Ferner kann eine Oberfläche mit einer höheren Härte höheren Klemmkräften ausgesetzt werden. Eine niedrige Härte und/oder eine hohe Elastizität kann die dreidimensional gedruckte Oberfläche aufweisen, wenn eine flexible Leiterplatte geformt werden soll. Ferner kann die Oberfläche den Trägerkörper komplett umschließen, um eine Hülle um den Trägerkörper auszubilden. Die unterschiedlich ausgebildeten Oberflächen können alle auf einem einzigen Trägerkörper ausgebildet sein.

Gemäß einer exemplarischen Ausführungsform ist ein Bereich der dreidimensional gedruckten Struktur aus Stahl und/oder Titan ausgebildet. Ist die dreidimensional gedruckte Struktur beispielsweise als eine Oberfläche des Trägerkörpers ausgebildet, so kann diese eine Hülle formen, wobei die Oberfläche. Damit wird der Trägerkörper vor Umwelteinflüssen geschützt. Die dreidimensional gedruckte Struktur kann den Trägerkörper zumindest teilweise oder auch komplett bedecken. Ferner kann durch die Verwendung von Titanmaterialien biokompatible Trägerkörper, bzw. Leiterplatten, hergestellt werden.

Gemäß einer exemplarischen Ausführungsform bildet die dreidimensional gedruckte Struktur zumindest einen Teil einer Komponente aus. Unter "Komponente" kann dabei eine Komponente verstanden werden, welche auf/in dem Trägerkörper angeordnet ist, um eine spezifische Funktion zu erfüllen, wie ein elektronisches Bauteil. Insbesondere kann die dreidimensional gedruckte Struktur eine Oberfläche der Komponente bilden, bzw. auf die Komponente als eine abschließende Oberfläche der Komponente aufgedruckt werden (z.B. als Hülle; wärmeableitende Struktur). Ferner kann die dreidimensional gedruckte Struktur die Komponente vollständig ausbilden, sodass eine dreidimensional gedruckte Komponente vorliegt.

Gemäß einer exemplarischen Ausführungsform ist zumindest ein Teil des Trägerkörpers mittels der dreidimensional gedruckten Struktur als Einkapselung zumindest teilweise eingekapselt. Die Einkapselung kann den Trägerkörper vollständig oder teilweise umschließen. Sollen nur bestimmte Bereiche des Trägerkörpers z.B. vor äußeren Einflüssen geschützt werden, so werden nur die zu schützenden Bereiche von der dreidimensional gedruckten Struktur eingekapselt. So werden zum Beispiel oberste Kupferschichten des Trägerkörpers eingekapselt, sodass diese Kupferschichten nicht freiliegen.

Gemäß einer exemplarischen Ausführungsform weist der Komponententräger ferner eine Komponente, insbesondere eine elektronische Komponente, oberflächenmontiert an und/ oder eingebettet in zumindest einer von der Mehrzahl von elektrisch leitfähigen Schichtstrukturen und/oder elektrisch isolierenden Schichtstrukturen auf. Die Komponente kann eine elektronische Komponente oder Vorrichtung zum Ausführen von verschiedenen Funktionen sein, in Abhängigkeit von der Anwendung in welche der Komponententräger eingebettet wird. Die Komponente kann oberflächenmontiert an und/oder eingebettet werden in zumindest einer von der Mehrzahl von elektrisch leitenden Schichtstrukturen und/oder oberflächenmontiert an und/oder eingebettet werden in zumindest einer von der Mehrzahl von elektrisch isolierenden Schichtstrukturen.

Gemäß einer exemplarischen Ausführungsform weist die dreidimensional gedruckte Struktur zumindest eine Materialkomponente auf, welche Kupfer und optional Aluminium, Stahl, Titan, Metalllegierung aufweist. Ferner kann die Materialkomponente Lot bzw. Lötzinn aufweisen.

Gemäß einer exemplarischen Ausführungsform ist die dreidimensional gedruckte Struktur derart ausgebildet, dass auf sie eine weitere dreidimensional gedruckte Struktur aufdruckbar ist. Das heißt, dass zuerst eine dreidimensional gedruckte Struktur auf zumindest einen Teil des Trägerkörpers aufgedruckt wird. Anschließend wird eine weitere dreidimensional druckbare Struktur auf die eine dreidimensional gedruckte Struktur aufgedruckt. Es können somit mehrere dreidimensional gedruckte Strukturen auf einander gedruckt werden. Somit kann beispielsweise die Schichtstruktur (d.h. die Stapel) des Trägerkörpers erzeugt werden.

Gemäß einer exemplarischen Ausführungsform ist ein weiterer Teil des Komponententrägers als weitere dreidimensional gedruckte Struktur ausgebildet, wobei die dreidimensional gedruckte Struktur und die weitere dreidimensional gedruckte Struktur aus unterschiedlichen Materialien bestehen. Der Komponententräger besteht somit aus einem Teil, welcher als eine dreidimensional gedruckte Struktur ausgebildet ist und aus einem weiteren Teil, welcher aus einer weiteren dreidimensional gedruckten Struktur ausgebildet ist. Die dreidimensional gedruckten Strukturen können sich dabei in ihren Materialien und in ihren Eigenschaften unterscheiden, um verschiedene Funktionen zu erfüllen. Beispielsweise kann eine dreidimensional gedruckte Struktur elektrisch leitend sein und die weitere dreidimensional gedruckte Struktur kann elektrisch isolierend sein.

Gemäß einer exemplarischen Ausführungsform weist die eine dreidimensional gedruckte Struktur eine höhere Wärmeleitfähigkeit und/oder Stromleitfähigkeit als die weitere dreidimensional gedruckte Struktur auf. Materialien mit unterschiedlicher Wärmeleitfähigkeit können als Isolierung verwendet werden.

Gemäß einer exemplarischen Ausführungsform ist die weitere dreidimensional gedruckte Struktur aus einem elektrisch leitenden Material, insbesondere Aluminium, ausgebildet. Da sich Aluminium als schwierig zu löten erweist, ist es von Vorteil das Aluminium als dreidimensional gedruckte Struktur direkt auf einen Komponententräger aufzubringen. Auf der anderen Seite ist es ebenfalls einfacher auf das Aluminium eine dreidimensional gedruckte Struktur aufzudrucken als aufzulöten, um somit eine bessere Haftung zwischen Aluminium und einem anderen Material (z.B. Kupfer) herzustellen.

Gemäß einer exemplarischen Ausführungsform sind die dreidimensional gedruckte Struktur und die weitere dreidimensional gedruckte Struktur übereinander ausgebildet zum Ausbilden eines Bimetallelementes. Bei der Ausbildung der dreidimensional gedruckten Strukturen als Bimetall weisen sowohl die eine dreidimensional gedruckte Struktur als auch die weitere dreidimensional gedruckte Struktur unterschiedliche Materialien auf. Zum Beispiel kann eine Kupferschicht aufgedruckt werden, auf welche eine andere Metallschicht aufgedruckt wird, um somit ein Bimetallstreifen zu bilden. Mittels dieses Aufbaues kann durch die dadurch entstehenden Dehnungseffekte ein Sensor (oder ein Relais, Termometer, Energy Harvester) ausgebildet werden.

Gemäß einer exemplarischen Ausführungsform ist die dreidimensional gedruckte Struktur eine Antennenstruktur. Derzeitige Leiterplattenantennenlösungen umfassen entweder Microstrip-Antennen, welche während eines Standard Leiterplattenherstellungsprozesses gefertigt werden oder externe Antennen, welche als eine oberflächenmontierte (SMT) Antenne hergestellt oder mit separaten Verbindern angebracht wird. Um die Vorteile beider Varianten zusammenzubringen und um die Herstellungskosten zu verringern, kann eine dreidimensional gedruckte Antenne verwendet werden. Damit wird eine Antenne mit besseren Antennencharakteristika und meiner hohen Designfreiheit herstellbar, welche direkt auf den Komponententräger bzw. die Leiterplatte aufbringbar ist. Diese dreidimensional gedruckte Antenne kann bei Radar-, IoT (Internet of Things) oder GPS-Anwendungen verwendet werden.

Gemäß einer exemplarischen Ausführungsform ist die Antennenstruktur derart ausgebildet, dass die Antennenstruktur direkt auf und/oder in den Trägerkörper aufdruckbar ist. Insbesondere kann die Antennenstruktur in/ auf zumindest eine der Mehrzahl von Schichtstrukturen gedruckt werden.

Gemäß einer exemplarischen Ausführungsform ist die dreidimensional gedruckte Struktur ausgebildet als zumindest eines aus einer Gruppe bestehend aus einem aktiven oder passiven elektronischen Bauelement, einem Widerstand, einem Kondensator, eine Spule, einem elektrischem Kontakt, einer Bruchsicherung, einem USB-Kontakt und einem QFN-Kontakt. Die dreidimensional gedruckte Struktur kann die oben genannten aktiven oder passiven elektronischen Bauelemente direkt ausbilden und somit auch deren Funktionen wahrnehmen. Beispielsweise können Widerstände in den Komponententräger derart integriert werden, indem verschiedene Metalle (oder auch Legierungen) mit 3D Druckverfahren gedruckt werden, sodass ein Widerstand geformt wird. Durch das dreidimensionale Drucken der Materialien können engere Toleranzen bei den Widerständen erzeugt werden als bei herkömmlichen Herstellungsverfahren.

Ein elektrischer Kontakt kann beispielsweise ein 3D gedruckter Adapter für elektronische Tests von Leiterplatten sein. Ferner können weitere verschiedene elektrische Kontakte auf und/oder in den Trägerkörper gedruckt werden (d.h. USB, QFN, Konverterschalter). Weiterhin können zwei verschiedene 3D gedruckte Strukturen realisiert werden, d.h. zum einen wird eine metallische 3D gedruckte Struktur realisiert, um das Gehäuse oder Befestigungsmittel eines Sockels eines elektrischen Kontaktes auszubilden und zum anderen wird eine elektrisch leitende 3D gedruckte Struktur gebildet, welche den elektrischen Kontakt selbst darstellt.

Wird die dreidimensional gedruckte Struktur als eine Bruchsicherung ausgebildet, umfasst dies eine mechanisch beanspruchbare 3D gedruckte Struktur mit der Möglichkeit bei einer definierten mechanischen Belastung zu brechen.

Gemäß einer exemplarischen Ausführungsform ist die dreidimensional gedruckte Struktur ausgebildet als zumindest eines aus einer Gruppe bestehend aus einem Sensor, einem Aktuator, einem magnetischen Sensor, EMV Schirmung und einem mikroelektromechanischen System.

Eine dreidimensional gedruckte EMV Schirmung kann eine vorgefertigte EMV Schirmung ersetzten und direkt auf den Komponententräger aufgedruckt werden. Durch das 3D Druckverfahren besteht in der Designauswahl der EMV Schirmung eine hohe Variabilität. Mittels eines dreidimensional gedruckten magnetischen Sensors kann beispielsweise ein drahtloser Lademechanismus realisiert werden, wobei magnetische Energie in elektrische Energie konvertiert wird. Es können Spulen auf der Oberfläche des Komponententrägers aufgedruckt werden, wobei eine Z-Achse der Spulen parallel zu der Komponententrägeroberfläche ist. Diese Ausführungsform kann als Sensor zum Detektieren von magnetsicher Flussdichte (bzw. Feldern von magnetischer Flussdichte) parallel zu der Komponententrägeroberfläche dienen.

Gemäß einer exemplarischen Ausführungsform ist die dreidimensional gedruckte Struktur ausgebildet als zumindest ein Element, welches ausgewählt ist aus der Gruppe bestehend aus einem Mikrophon, einem Lautsprecher und einem Helmholtzhorn. Das Helmholtzhorn, auch bekannt als sogenannter Helmholtz Resonator, kann beispielsweise verwendet werden, um einen Engpass für ungewünschte Frequenzen zu erzeugen, welche das Mikrophon erreichen und darin Störungen erzeugen würden. Mittels des 3D Druckens können komplexe Geometrien für entsprechende Anwendungen (wie entsprechende Helmholtz Resonatoren für bestimmte Frequenzen) realisiert werden.

Gemäß einer exemplarischen Ausführungsform kann die zumindest eine Komponente ausgewählt werden von einer Gruppe, welche besteht aus einem elektrisch nicht leitendem Inlay, einem elektrisch leitendem Inlay (wie ein Metallinlay), einer Wärmeabfuhreinheit (zum Beispiel ein Wärmerohr), eine elektronische Komponente, oder Kombinationen daraus. Zum Beispiel kann die Komponente sein eine aktive elektronische Komponente, eine passive elektronische Komponente, ein elektronsicher Chip, eine Speichervorrichtung (zum Beispiel ein DRAM oder ein anderer Datenspeicher), ein Filter, ein integrierter Schaltkreis, eine Signalverarbeitungskomponente, einer Leistungsmanagementkomponente, ein optoelektrischen Wandler, ein Spannungswandler (zum Beispiel ein DC/DC Konverter oder AC/DC Konverter), eine kryptografischen Komponente, eine Sende- und/ oder Empfangseinheit, ein elektromechanischer Wandler, ein Aktuator, ein mikroelektromechanisches System (MEMS), ein Mikroprozessor, eine Kapazität, ein Widerstand, eine Induktivität, ein Akkumulator, ein Schalter, eine Kamera, eine Antenne, ein magnetisches Element, einen weiteren Komponententräger, einen Logik Chip und eine Energiegewinnungseinheit. Dennoch können auch andere Komponenten in dem Bauteilträger eingebettet werden. Zum Beispiel ein magnetisches Element kann als Komponente verwendet werden. Solch ein magnetisches Element kann ein Permanentmagnet Element (wie ein ferromagnetisches Element, ein antiferromagnetisches Element oder ein ferrimagnetisches Element, zum Beispiel ein Ferritkern) oder paramagnetisches Element sein. Dennoch kann die Komponente auch ein weitere Komponententräger sein, zum Beispiel eine Board in Board Konfiguration. Die Komponente kann Oberflächen montiert auf dem Komponententräger sein und/ oder in einem Inneren davon eingebettet sein. Zudem können auch andere Komponenten als Komponente verwendet werden, insbesondere solche welche elektromagnetische Strahlung generieren und aussenden und/ oder sensitiv sind im Hinblick auf elektromagnetische Strahlung, welche von einer Umgebung ausgesendet wird.

Gemäß einer exemplarischen Ausführungsform der Erfindung weist zumindest eine von der Mehrzahl von den elektrisch isolierenden Schichtstrukturen zumindest eines von der Gruppe auf bestehend aus Harz (wie verstärktem oder nicht verstärkte Harze, beispielsweise Epoxidharz oder Bismaleimide-Triazin Harz, mehr insbesondere FR-4 oder FR-5), Zyanat Ester, Polyphenylen Derivate, Glass (insbesondere Glasfasern, Mehrschicht Glas, Glasähnliche Materialien), Prepreg Material, Polyimid, Polyamid, flüssigkristallines Polymer (LCP), Epoxid basierten Aufbau Film, Polytetrafluorethylen (Teflon), eine Keramik, und ein Metalloxid. Verstärkte Materialien wie Gewebe, Fasern oder Kugeln, zum Beispiel aus Glas (Mehrschicht Gals) gefertigt können auch verwendet werden. Obwohl Prepreg oder FR4 üblicherweise bevorzugt wird sind auch andere Materialien möglich. Für hochfrequente Anwendungen können in den Komponententräger als elektrisch isolierende Schichtstruktur hochfrequente Materialien, wie Polytetrafluorethylen, flüssigkristallin Polymer und/ oder Zyanat Ester Harze implementiert werden.

Gemäß einer Ausführungsform der Erfindung ist der Komponententräger als Platte geformt. Dies trägt zu dem kompakten Design bei, wobei der Komponententräger dennoch eine große Basis zum Befestigung von Komponenten bereitstellt. Weiterhin, kann insbesondere ein nackter Chip, als Beispiel für eine eingebettete elektronische Komponente, wegen der geringen Dicke, in eine dünne Platte, wie eine Leiterplatte, herkömmlicherweise eingebettet werden.

Gemäß einer Ausführungsform der Erfindung ist der Komponententräger konfiguriert als eines aus der Gruppe, welche besteht aus einer Leiterplatte und einen Substrat (insbesondere ein IC Substrat).

Unter dem Begriff "Leiterplatte" (PCB) wird insbesondere ein Komponententräger verstanden (welcher plattenförmig (d.h. planar), dreidimensional gekrümmt ist (zum Beispiel wenn er unter Verwendung von 3D drucken hergestellt wird) oder welcher jede andere Form haben kann), welcher mittels Laminierens von mehreren elektrisch leitfähigen Schichtstrukturen mit mehreren elektrisch isolierenden Schichtstrukturen geformt wird, beispielsweise mittels Anwendens von Druck, wenn gewünscht wird dies mittels der Zufuhr von thermischer Energie begleitet. Als präferiertes Materialien für die PCB Technologie sind die elektrisch leitenden Schichtstrukturen aus Kupfer, wobei die elektrisch isolierenden Schichtstrukturen ein Harz und/ oder Glasfasern aufweisen, ein sogenanntes Prepeg oder FR4 Material. Die verschiedenen elektrisch leitenden Schichtstrukturen können miteinander verbunden sein in einer gewünschten Art und Weise mittels Formens von Durchgangslöchern durch das Laminat, zum Beispiel mittels Laserbohrens oder mechanischen Bohrens und mittels Auffüllen dieser mit elektrisch leitendem Material (insbesondere Kupfer), um somit Vias als Durchganslochverbindung zu bilden. Abgesehen von einem oder mehreren Komponenten, welche in einer Leiterplatte eingebettet sein können, ist eine Leiterplatte üblicherweise konfiguriert zum Aufnehmen eines oder mehrerer Komponenten auf einer oder gegenüberliegenden Oberflächen von der plattenförmigen Leiterplatte. Diese können mittels Lötens zu der jeweiligen Hauptoberfläche verbunden sein. Ein dielektrischer Teil von einer Leiterplatte kann aus Harz mit Verstärkungsfasern bestehen (wie Glasfasern).

Unter dem Begriff "Substrat" wird insbesondere ein kleiner Komponententräger verstanden, welcher im Wesentlichen dieselbe Größe wie eine darauf befestigte Komponente hat (insbesondere eine elektronische Komponente). Speziell kann ein Substrat als ein Träger für elektronische Verbindungen oder elektrische Netzwerke verstanden werden genauso als Komponententräger vergleichbar mit einer Leiterplatte (PCB), hingegen mit einer beträchtlich höheren Dichte von lateral und/ oder vertikal angeordneten Verbindungen. Laterale Verbindungen sind zum Beispiel leitende Pfade wobei vertikale Verbindungen zum Beispiel Bohrlöcher sein können. Diese lateralen und/ oder vertikalen Verbindungen sind innerhalb des Substrates angeordnet und können verwendet werden, um elektrische und/ oder mechanische Verbindungen von untergebrachten Komponenten oder nicht untergebrachten Komponenten (wie freiliegende Chips), insbesondere von IC Chips, mit einer Leiterplatte oder zwischenliegenden Leiterplatte bereitzustellen. Daher umfasst der Begriff "Substrat" auch "IC Substrate". Ein dielektrischer Teil von einem Substrat kann aus Harz mit verstärkten Kugeln (wie Glaskugeln).

In einer Ausführungsform ist der Komponententräger ein Laminat-Typ Komponententräger. In solch einer Ausführungsform ist der Komponententräger eine Zusammensetzung von mehreren Schichtstrukturen, welche gestapelt und miteinander verbunden sind mittels Anwendens einer Druckkraft und welche wenn gewünscht von Wärme begleitet wird.

Im Folgenden werden weitere exemplarische Ausführungsformen des Verfahrens zum Herstellen eines Komponententrägers beschrieben.

In einer exemplarischen Ausführungsform des Verfahrens weist das dreidimensionale Drucken ein Einbringen eines druckbaren Materials in eine Verarbeitungsvorrichtung auf. Ferner weist das Verfahren ein Schmelzen des druckbaren Materiales in der Verarbeitungsvorrichtung auf und ein Zuführen des geschmolzenen druckbaren Materials auf und/oder in den Trägerkörper zum Formen zumindest einer Schicht von zumindest einem Teil der dreidimensional gedruckten Struktur. Gemäß dieser Ausführungsform wird für das 3D Drucken schmelzbares Material verwendet. Das Material kann in einen 3D Drucker eingebracht werden. Der 3D Drucker kann einen Druckkopf aufweisen, welcher als Verarbeitungsvorrichtung fungiert. Der Druckkopf kann ein aufheizbarer Extruder sein, in welchem das Material zugeführt wird. Innerhalb des Extruders wird das Material geschmolzen, so dass das Material durch den Extruder (zum Beispiel durch eine Extruderdüse) zu einer Struktur transferiert werden kann, auf welcher das geschmolzene Material aufgebracht und/oder eingebracht werden soll (wie z.B. auf zumindest eine der Schichtstrukturen). Die Verarbeitungsvorrichtung und der Trägerkörper können relativ zu einander bewegt werden. Nach dem die eingebrachte/aufgebrachte Schicht des Teiles des Trägerkörpers verfestigt (ausgehärtet) ist wird nachfolgend eine weitere Schicht des Teiles des Trägerkörpers mittels des Extruders geformt. Die Anzahl der gebildeten Schichten des einen Teils des Trägerkörpers sind von der Größe, insbesondere von der Höhe, des einen Teils des Trägerköpers abhängig. Zum Beispiel kann eine gebildete Schicht eine Dicke (bzw. Höhe) von 50µm haben. Der Teil des Trägerkörpers kann eine Dicke (bzw. Höhe) von 200µm haben. Daher werden vier Schichten übereinander gedruckt, um den Teil des Trägerkörpers zu formen. Zum Beispiel kann die Verarbeitungsvorrichtung eine hohe Auflösung haben, sodass einzelne Schichten eine Dicke von näherungsweise 1µm bis 16 µm aufweisen. Ferner können während des Herstellungsprozesses mehr als eine Verarbeitungsvorrichtung verwendet werden, um verschiedene Materialien gleichzeitig aufzubringen und/oder um verschiedene Schichten von unterschiedlichen Teilen des Trägerkörpers zu bilden. Gemäß dieser Ausführungsform kann es möglich sein mehr als einen Teil des Trägerkörpers gleichzeitig zu drucken. Dabei können zwei Teile desselben Trägerkörpers in und/oder auf verschiedenen Ebenen des Trägerkörpers oder auf verschiedenen Schichtstrukturen gebildet werden.

Gemäß einer weiteren Ausführungsform des Verfahrens weist das dreidimensionale Drucken ein Aufbringen eines druckbaren Materiales, insbesondere eines pulverförmigen Materials, auf und/ oder in den Trägerkörper auf und ein Verfestigen bzw. Konsolidieren des aufgebrachten druckbaren Materiales zum Formen zumindest einer Schicht von zumindest einem Teil der dreidimensional gedruckte Struktur. Der Begriff "Verfestigen/Konsolidieren" kann insbesondere einen Schritt oder eine Aktivität bezeichnen, bei welcher das druckbare Material in einen festen Zustand gebracht wird, wobei der feste Zustand ein Zustand von der zumindest einen Schicht von dem zumindest einem Teil der dreidimensionalen Struktur ist. Zum Beispiel kann das Verfestigen/Konsolidieren zumindest eines von den folgenden sein: Anhaften, Kleben, Aushärten, Tempern, Verfestigen, Schmelzen und Härten oder Härten des druckbaren Materials. Das Bilden der zumindest einen Schicht des Teils des Trägerkörpers kann mittels Aufbringens eines Adhäsives auf die zumindest eine Schicht von dem Teil des Trägerkörpers durchgeführt werden. Das Adhäsiv verklebt die einzelnen Partikel des pulverförmigen Materials zusammen, sodass eine entsprechende Schicht gebildet wird. Das Adhäsiv kann mittels eines Druckkopfes auf die Pulverschicht aufgebracht werden. Das Adhäsiv (oder auch Bindemittel) kann ein fluidisches Adhäsiv sein. Während des 3D Druckens mit Pulver wird die erste (unterste) Schicht mit Hilfe des fluidischen Adhäsivs auf die Pulverschicht aufgebracht. Der 3D Drucker zeichnet ein 3D Bild auf die erste Schicht des Pulverbettes und klebt die Materialpartikel des Pulvers zusammen. Nach diesem Schritt wird eine weitere dünne Pulverschicht auf die erste Schicht aufgebracht und die 3D Druckprozedur wird zum Erzeugen einer zweiten Schicht wiederholt. Somit wird ein 3D Model des einen Teils des Komponententrägers Schicht für Schicht durch das zusammenkleben von Pulverschichten erzeugt. Die 3D Struktur wächst in diesem Fall von unten nach oben. Dafür wird das Pulverbett um die Höhe einer Pulverschicht herabgesenkt. Das Pulver und das Adhäsiv herabgesenkt aus verschiedenen Materialien. Ebenfalls ist es möglich das Kupfer als Pulvermaterial zum 3D Drucken von leitenden Teilen des Komponententrägers zu verwenden. Der 3D Drucker kann mit zumindest einem Druckkopf ausgestattet sein oder auch mit mehreren Druckköpfen. Das verwendete Adhäsiv kann ein leitendes Adhäsiv sein, so dass Schichtstrukturen mittels leitenden Metallpulvers und leitendem Adhäsiv gebildet werden um elektrisch leitend zu sein. Das Adhäsiv kann mittels einer thermischen Behandlung ausgehärtet werden, wie eine Wärmelampe oder einem Laser.

Gemäß der Erfindung wird die dreidimensional gedruckte Struktur geformt mittels zumindest einem aus einer Gruppe bestehend aus Selektiven Laser Schmelzen, Selektiven Laser Sintern und Elektronenstrahlschmelzen.

Gemäß einer weiteren exemplarischen Ausführungsform des Verfahrens wird vor dem Verfestigen/Konsolidieren des druckbaren Materials das druckbare Material mittels einer thermischen Behandlungsvorrichtung, insbesondere einer Laservorrichtung, geschmolzen. Anstatt ein Adhäsiv zu verwenden, welche die Materialpartikel miteinander verklebt, können die einzelnen Schichten geschmolzen werden und zwar mittels einer thermischen Behandlungsvorrichtung, wie einem Laser. Dieses thermische Behandlungsverfahren wird Selektives Laser Sintern (SLS) oder Selektiven Laser Schmelzen (SLM) genannt. Wenn SLS oder SLM als Herstellungsverfahren verwendet wird, wird das Ausbilden der Schicht von dem Pulvermaterial mittels eines Lasers durchgeführt, wobei der Laser das Pulvermaterial schmilzt oder sintert um zumindest eine Schicht des einen Teils des Komponententrägers zu bilden. Bei der Verwendung von SLS oder SLM Verfahren ist eine Verwendung eines Adhäsivs zum Verbinden der Pulverpartikel überflüssig.

Ferner kann das druckbare Material mittels eins steuerbaren Elektronenstrahles geschmolzen werden, was als sogenanntes Elektronenstrahlschmelzen (EBM) bezeichnet wird.

Gemäß einer weiteren exemplarischen Ausführungsform des Verfahrens wird das druckbare Material mittels einer Materialzuführdüse aufgebracht. Das druckbare Material, z.B. Pulver, wird mittels der Materialzuführdüse bereitgestellt, so dass das aufzubringende druckbare Material aus der Materialzuführdüse heraus gesprüht wird. Mittels der Materialzuführdüse kann eine präzise Materialmenge bereitgestellt werden. sodass nur der zu druckende Teil des Komponententrägers mit einer (neuen) Schicht druckbaren Materials bedeckt werden muss, anstatt des kompletten Komponententrägers.

Gemäß einer weiteren exemplarischen Ausführungsform weist das Verfahren ferner auf Bewegen der Materialzuführdüse zum Formen einer weiteren Schicht von dem zumindest einen Teil der dreidimensional gedruckten Struktur. Unter dem Begriff "Bewegen", kann insbesondere eine Bewegung entlang zumindest einer räumlichen Richtung verstanden werden. Ferner kann darunter ein Einstellen der Materialzuführdüse in Bezug auf den Trägerköper verstanden werden. Zum Beispiel, kann ein Abstand zwischen dem Trägerkörper und der Materialzuführdüse eingestellt werden. Weiterhin, kann die Materialzuführdüse entlang weitere räumlicher Richtungen bewegt werden, um eine gewünschte Ausrichtung zwischen dem Trägerkörper und der Materialzuführdüse einzustellen. In Abhängigkeit von der Bewegung der Materialzuführdüse kann die Dicke und der Ort der zu bildenden Schicht eingestellt werden. Dieser Schritt kann solange wiederholt werden, bis eine finale Dicke des einen Teils der dreidimensional gedruckten Struktur erhalten wird. Somit wird der eine Teil der dreidimensional gedruckten Struktur Schicht für Schicht mittels Aufsprühens von druckbaren Material ausgebildet.

Gemäß einer weiteren exemplarischen Ausführungsform wird der Trägerkörper in einem Materialbett bereitgestellt, bevor das druckbare Material dem Trägerkörper zugeführt wird. Der Trägerkörper kann in dem Materialbett platziert werden. Der Komponententräger kann komplett durch das druckbare Material bedeckt werden, wenn der Komponententräger in dem Materialbett angeordnet wird. Ferner kann der Trägerkörper so in dem Materialbett angeordnet sein, sodass eine Oberfläche des Trägerkörpers, auf welcher der eine Teil der dreidimensional gedruckten Struktur gebildet wird, mit einem definierten Abstand zu einer Oberfläche von dem Materialbett angeordnet ist. Daher kann zwischen der Umgebung und der Oberfläche des Trägerkörpers eine gewünschte Dicke des druckbaren Materials aufgebracht werden. Danach wird das aufgebrachte druckbare Material zwischen der Oberfläche von dem Materialbett und dem Trägerkörper verfestigt. Die Verfestigung bzw. Konsolidierung kann mittels einer Behandlungsvorrichtung durchgeführt werden, welche zum Anwenden von thermischer Energie auf die Oberfläche des Materialbettes ausgebildet sein kann.

Gemäß einer weiteren exemplarischen Ausführungsform weist das Verfahren ferner auf ein Bewegen des Trägerkörpers zum Formen einer weiteren Schicht von dem zumindest einen Teil der dreidimensional gedruckten Struktur. Nach dem Drucken einer Schicht des einen Teils der dreidimensional gedruckten Struktur auf/in dem Trägerkörper kann der Trägerkörper bewegt werden. Insbesondere kann der Trägerkörper um die Dicke der nächsten zu druckenden Schicht des einen Teils der dreidimensional gedruckten Struktur abgesenkt werden.

Gemäß einer weiteren exemplarischen Ausführungsform weist das Verfahren das Anordnen des Trägerkörpers in einem Behälter auf. Ferner weist das dreidimensionale Drucken ein Bereitstellen eines verfestigbaren Fluidmaterials in dem Behälter und ein Verfestigen des Fluidmaterials mittels einer Behandlungsvorrichtung auf, insbesondere einer Laservorrichtung, auf und/ oder in dem Trägerkörper zum Formen zumindest einer Schicht von zumindest einem Teil der dreidimensional gedruckten Struktur. Insbesondere wird das Fluidmaterial nach dem Anordnen des Trägerkörpers verfestigt. Ein Ultraviolett Laser kann zum Verfestigen verwendet werden. Der Laser wird dabei auf den Behälter fokussiert, welcher das Fluidmaterial enthält. Der Laser kann verwendet werden, um gewünschte Bereiche des Fluidmaterials zu verfestigen um ein definiertes Design des einen Teils der dreidimensional gedruckten Struktur auszubilden. Das Fluidmaterial kann verfestigt werden, insbesondere ausgehärtet, und bildet eine einzelne Schicht des gewünschten einen Teils der dreidimensional gedruckten Struktur. Diese Schritte können für jede zu druckende Schicht des einen Teils wiederholt werden. Um den Trägerkörper oder die Oberfläche, auf welche das eine Teil 3D gedruckt werden soll, zu bewegen, kann eine Liftplattform verwendet werden. Die Liftplattform kann um einen Abstand bewegt werden, welcher einer Dicke von einer einzelnen Schicht der zu druckenden Struktur in dem Behälter entspricht. Nach dem Verfestigen kann eine Abschabvorrichtung bzw. ein Messer über die verfestigte Schicht hinweggefahren werden und Material abstreichen, um eine homogene Verteilung des Fluidmaterials für die nächste 3D zu druckende Schicht bereitzustellen. Danach verfestigt der Laser weitere gewünschte Bereiche des Fluidmaterials zum Bilden des gewünschten Designs des einen Teils der dreidimensional gedruckten Struktur. Diese Schritte können wiederholt werden bis die gewünschte 3D Struktur erhalten wird.

Gemäß einer weiteren exemplarischen Ausführungsform weist das Verfahren ferner auf Bewegen des Trägerkörpers zum Formen einer weiteren Schicht von dem zumindest einem Teil der dreidimensional gedruckten Struktur.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

### Kurze Beschreibung der Zeichnungen

Im Folgenden werden zur weiteren Erläuterung und zum besseren Verständnis der vorliegenden Erfindung Ausführungsbeispiele unter Bezugnahme auf die beigefügten Zeichnungen näher beschrieben.
Fig. 1 zeigt einen Komponententräger gemäß einer exemplarischen Ausführungsform der Erfindung.
Fig. 2 zeigt einen Komponententräger mit einer Einkapselung gemäß einer exemplarischen Ausführungsform der Erfindung.
Fig. 3 zeigt einen Komponententräger mit einem umgebenden Komponententrägerbereich und einen umgebenen Komponententrägerbereich gemäß einer exemplarischen Ausführungsform der Erfindung.
Fig. 4 zeigt einen Komponententräger mit Verbindungselementen gemäß einer exemplarischen Ausführungsform der Erfindung.
Fig. 5 zeigt ein Verbindungselement an einem Komponententräger gemäß einer exemplarischen Ausführungsform der Erfindung.
Fig. 6 zeigt einen Schleifkontakt an einem Komponententräger gemäß einer exemplarischen Ausführungsform der Erfindung.
Fig. 7 zeigt einen Querschnitt durch einen Schleifkontakt an einem Komponententräger gemäß einer exemplarischen Ausführungsform der Erfindung.
Fig. 8 zeigt einen weiteren Querschnitt durch einen Schleifkontakt an einem Komponententräger gemäß einer exemplarischen Ausführungsform der Erfindung.
Fig. 9 zeigt einen Komponententräger mit einer Einkapselung gemäß einer exemplarischen Ausführungsform der Erfindung.
Fig. 10 zeigt eine andere Ansicht des Komponententrägers mit der Einkapselung gemäß einer exemplarischen Ausführungsform der Erfindung.
Fig. 11 zeigt einen Komponententräger mit Aluminiumschichten gemäß einem Vergleichsbeispiel, das nicht zur Erfindung gehört.
Fig. 12 zeigt einen Komponententräger mit 3D bedruckten Aluminiumschichten gemäß einer exemplarischen Ausführungsform der Erfindung.
Fig. 13 zeigt eine andere Ansicht des Komponententrägers mit 3D bedruckten Aluminiumschichten gemäß einer exemplarischen Ausführungsform der Erfindung.
Fig. 14 zeigt einen Komponententräger mit Dämpfungselementen gemäß einer exemplarischen Ausführungsform der Erfindung.
Fig. 15 zeigt einen Komponententräger mit Verbindungselementen gemäß einer exemplarischen Ausführungsform der Erfindung.
Fig. 16 zeigt einen Komponententräger mit einer Verstärkungsstruktur und/oder einer wärmeleitenden Struktur gemäß einer exemplarischen Ausführungsform der Erfindung.
Fig. 17 zeigt ein dreidimensionales Druckverfahren gemäß einer exemplarischen Ausführungsform der Erfindung.
Fig. 18 zeigt einen Komponententräger mit verschiedenen dreidimensional gedruckten Strukturen gemäß einer exemplarischen Ausführungsform der Erfindung.
Fig. 19 zeigt einen Komponententräger mit 3D gedruckten Glasfasern gemäß einer exemplarischen Ausführungsform der Erfindung.
Fig. 20 zeigt einen Komponententräger mit einer Gewindebuchse gemäß einer exemplarischen Ausführungsform der Erfindung.
Fig. 21 zeigt einen Komponententräger mit einer Gewindebuchse und einem Befestigungselement gemäß einer exemplarischen Ausführungsform der Erfindung.
Fig. 22 zeigt einen Komponententräger mit einer dreidimensional gedruckten Struktur und einer weiteren dreidimensional gedruckten Struktur gemäß einer exemplarischen Ausführungsform der Erfindung.
Fig. 23 zeigt einen Komponententräger mit einem optischen Element gemäß einem Vergleichsbeispiel, das nicht zur Erfindung gehört.
Fig. 24 zeigt einen Komponententräger mit einer Brücke gemäß einer exemplarischen Ausführungsform der Erfindung.
Fig. 25 zeigt einen Komponententräger mit einer Brücke gemäß einer weiteren exemplarischen Ausführungsform der Erfindung.
Fig. 26 zeigt einen Komponententräger mit einem Wellenleiter gemäß einem Vergleichsbeispiel, das nicht zur Erfindung gehört.
Fig. 27 zeigt einen Komponententräger mit einer dreidimensional gedruckten Struktur ausgebildet als zumindest ein Teil einer Komponente.

### Detaillierte Beschreibung von exemplarischen Ausführungsformen

Gleiche oder ähnliche Komponenten in unterschiedlichen Figuren sind mit gleichen Bezugsziffern versehen. Die Darstellungen in den Figuren sind schematisch.

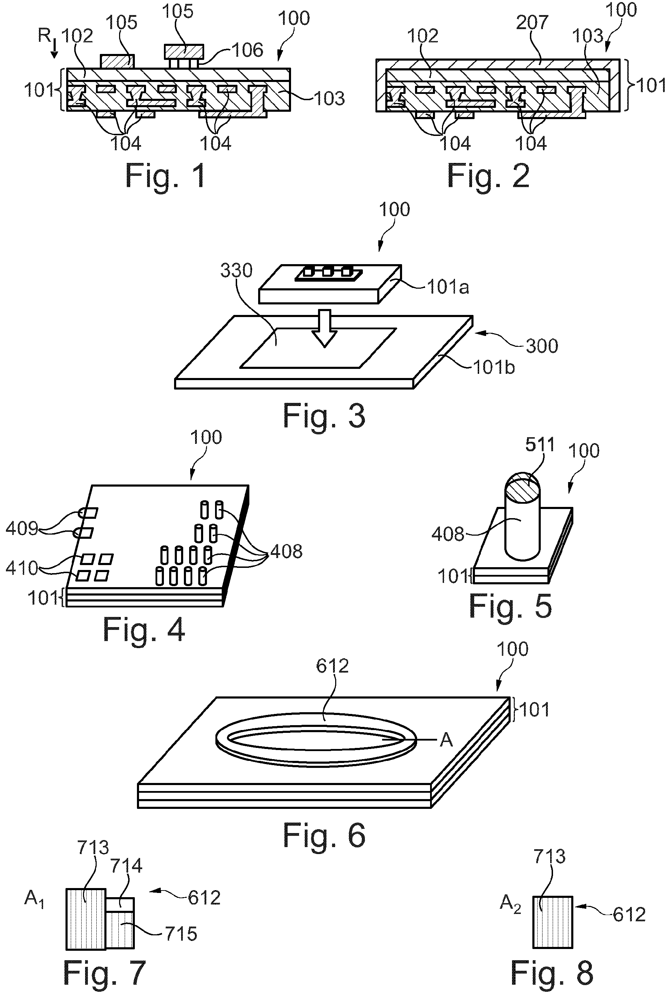

Im Folgenden unter Bezugnahme auf **Fig. 1** wird ein Komponententräger 100 beschrieben, wobei der Komponententräger 100 einen Trägerkörper 101 aufweist. Der Trägerkörper 101 umfasst eine Mehrzahl von elektrisch leitfähigen Schichtstrukturen 104 und/oder elektrisch isolierenden Schichtstrukturen 103. Zumindest ein Teil des Komponententrägers 100 ist als dreidimensional gedruckte Struktur ausgebildet. So kann die dreidimensional gedruckte Struktur teilweise die elektrisch leitfähigen Schichtstrukturen 104ausbilden. Die dreidimensional gedruckte Struktur kann im Inneren und/oder an einer Oberfläche des Trägerkörpers 101 geformt sein. In Fig. 1 kann die dreidimensional gedruckte Struktur als elektrisch leitende Schichtstruktur 104 auf der Oberfläche des Trägerkörpers 101 ausgebildet sein. Die dreidimensional gedruckte Struktur ist entlang einer Stapelrichtung R der Mehrzahl von Schichtstrukturen geformt.

Wie in Fig. 1 zu erkennen sind die inneren elektrisch leitenden Schichtstrukturen 104 auf einer elektrisch isolierenden Schichtstruktur 103 ausgebildet. Ferner wird die unterste Schicht wieder aus einer Schicht von elektrisch leitenden Schichtstrukturen 104 gebildet, sodass der Trägerkörper 101 aus gestapelten Schichtstrukturen 103, 104 besteht. Ferner kann die dreidimensional gedruckte Struktur senkrecht zu einer Stapelrichtung R der Mehrzahl von Schichtstrukturen geformt sein.

Der Komponententräger 100 weist ferner zumindest eine Komponente 105, insbesondere eine elektronische Komponente 105, auf, welche oberflächenmontiert an und/ oder eingebettet in zumindest einer von der Mehrzahl von elektrisch leitfähigen Schichtstrukturen 104 und/oder elektrisch isolierenden Schichtstrukturen 103 ist. Die Komponente 105 ist direkt auf dem Trägerkörper 101 angeordnet oder mittels Verbindungselementen 106 auf dem Trägerkörper 101 befestigt. In Fig. 1 sind die Komponenten 105 auf dem Trägerkörper 101 angeordnet.

Im Folgenden unter Bezugnahme auf **Fig. 2** wird ein Komponententräger 100 dargestellt, wobei zumindest ein Teil des Trägerkörpers 101 mittels der dreidimensional gedruckten Struktur als Einkapselung 207 zumindest teilweise eingekapselt ist. Der Trägerkörper 101 weist zumindest eine Seite auf, welche frei von der Einkapselung 207 ist. Auf der Seite, welche frei von der Einkapselung 207 ist, sind elektrisch leitende Schichtstrukturen 104 angeordnet. Diese elektrisch leitenden Schichtstrukturen 104 sind frei von der Verkapselung, um zu entsprechenden anderen Komponenten elektrische Kontakte herzustellen. Die Einkapselung 207 weist eine U-Form auf. Andere Formen der Einkapselung 207 sind ebenfalls möglich, wie eine ovale oder eine abgerundete Form. Die Einkapselung 207 wird entsprechend an die Form des Komponententrägers 100 angepasst. Ferner kann die Einkapselung verschiedene Querschnitte sowohl entlang einer Stapelrichtung als auch senkrecht zu einer Stapelrichtung aufweisen, um somit verschiedenen Anforderungen gerecht zu werden. Soll die Einkapselung beispielsweise vor äußeren Einflüssen, wie vor starken Belastungen, geschützt werden, so wird ein dickerer Querschnitt verwendet, als bei einer Einkapselung 207 für leichte Beanspruchungen.

Gemäß Fig. 2 kann zumindest eine der Mehrzahl von Schichtstrukturen 103 ,104 als dreidimensional gedruckte Struktur ausgebildet sein, wobei auf sie eine weitere dreidimensional gedruckte Struktur aufdruckbar ist. In Fig. 2 ist auf die dreidimensional gedruckte Struktur der Kupferschicht 102 und zumindest einer der Mehrzahl von Schichtstrukturen 103 ,104 die Einkapselung 207 als weitere dreidimensional gedruckte Struktur aufgedruckt.

Im Folgenden unter Bezugnahme auf **Fig. 3** wird ein Komponententräger 100 dargestellt, welcher einen umgebenden Komponententrägerbereich 101b und einen umgebenen Komponententrägerbereich 101a aufweist, der von dem umgebenden Komponententrägerbereich 101b umgeben ist, wobei insbesondere zumindest ein Teil des umgebenden Komponententrägerbereichs 101b und/oder des umgebenen Komponententrägerbereichs 101a als weitere dreidimensional gedruckte Struktur ausbildbar ist. Mit anderen Worten kann der Komponententräger 100 zwei Bereiche von Trägerkörpern 101a, 101b aufweisen, wobei ein erster Bereich des Trägerkörpers 101a ein innerer Bereich ist und ein zweiter Bereich des Trägerkörpers 101b ein äußerer Bereich ist, welcher den inneren Bereich des Trägerkörpers 101a umgibt. Der zweite Bereich des Trägerkörpers 101b (oder der umgebende Komponententrägerbereich 101b) weist eine Ausnehmung 330 auf innerhalb, welcher der erste Bereich des Trägerkörpers 101a ausgebildet wird. Insbesondere wird der erste Bereich des Trägerkörpers 101a innerhalb der Ausnehmung 330 dreidimensional gedruckt. Auf der anderen Seite ist es auch möglich, dass der Komponententräger 100 in einer Ausnehmung 330 eines weiteren Komponententrägers 300 dreidimensional gedruckt wird. In diesem Falle liegen somit zwei verschiedene Komponententräger 100, 300 vor, welche mittels 3D Druckverfahren hergestellt werden können.

Im Folgenden unter Bezugnahme auf **Fig. 4** wird ein Komponententräger 100 dargestellt, bei welchem die dreidimensional gedruckte Struktur zumindest teilweise als elektrisch leitendendes Verbindungselement 408, 409, 410, insbesondere als ein Anschlusspad 410, ein Pin 408, eine Buchse, ein Mikropin 408 ausgebildet ist. Auf dem Trägerkörper 101 sind eine Mehrzahl von Pins 408 angeordnet, welche elektrische Kontakte für Komponenten 105 darstellen. Ferner sind auf dem Trägerkörper Anschlusspads 410 bzw. Lötpads angeordnet, auf welchen Komponenten 105 direkt befestigt werden können und/oder auf welchen Pins oder andere elektrische Leiter befestigt werden können, um den Trägerkörper 101 zu weiteren elektrischen Elementen (wie zum Beispiel elektrischen Komponenten oder elektrischen Vorrichtungen) zu verbinden.

Im Folgenden unter Bezugnahme auf **Fig. 5** wird ein Komponententräger 100 dargestellt auf dessen Trägerkörper 101 ein Pin 408 dreidimensional aufgedruckt wurde, wobei als weitere dreidimensional gedruckte Struktur auf den Pin 408 ein Lötdepot 510 aufgedruckt wurde. Der Pin 408 kann somit gleich mit einem entsprechenden Lötdepot 510 ausgestattet werden. Auch andere elektrische Kontakte, wie zum Beispiel Kontakte, oder Lötpads, wie in Fig. 4 gezeigt, können mit einem Lötdepot 510 bedruckt werden.

Im Folgenden unter Bezugnahme auf **Fig. 6** wird die dreidimensional gedruckte Struktur zumindest teilweise als elektrisch leitendendes Verbindungselement, insbesondere als ein ringförmiger, Schleifkontakt 612 ausgebildet. Der Schleifkontakt 612 stellt elektrische Verbindungen zwischen bewegten Teilen her, dabei schleift beispielsweise ein Stromabnehmer über eine Metalloberfläche und greift die elektrische Energie ab. Durch die Verwendung eines 3D gedruckten Materiales für den Schleifkontakt 612 können Materialien, insbesondere Metalle und/oder Metalllegierungen, verwendet werden, welche widerstandsfähig gegen chemische, mechanische und thermische Belastungen sind. Je nachdem welche Schichtdicke für den Schleifkontakt 612 gewählt wird ist dieser bei einer hohen Schichtdicke weniger anfällig für mechanischen Abrieb als Schleifkontakte mit geringer Schichtdicke. Schleifkontakte 612 mit einer hohen Schichtdicke weisen daher auch eine längere Lebensdauer auf.

Im Folgenden unter Bezugnahme auf **Fig. 7** wird ein Querschnitt eines Schleifkontaktes 612 dargestellt. Der Schleifkontakt 612 besteht aus einer Materialkombination aus drei verschiedenen Materialien, d.h. Material A 713, Material B 714 und Material C 715. Material A 713 stellt eine stabile Metalllegierung gegen Abrieb dar und ist als ein Trägerring für den Schleifkontakt 612 ausgebildet. Material B 714 ist Gold, welches galvanisch auf Material C 715 aufgebracht wird oder mittels 3D Druckens auf Material C 715 aufgedruckt wird. Material B 714 dient hierbei als Abgriff für das elektrische Signal, wobei Gold einen guten elektrischen Leitwert hat, wodurch die Signalübertragung verbessert wird. Material C 715 ist ein Trägermetall für das Goldmaterial, Material C 715 ist Kupfer. Bei einem Schleifkontakt 612 mit einem solchen Aufbau lastet die mechanische Belastung vorwiegend auf Material A 714, sodass auf Material B 714 ein geringer Druck (und ein geringer Abrieb) wirkt, sodass Material B 714 eine längere Lebensdauer aufweist. Andere Materialien bzw. andere Metalllegierungen können ebenfalls verwendet werden.

Im Folgenden unter Bezugnahme auf **Fig. 8** wird ein Querschnitt eines Schleifkontaktes 612 dargestellt. Dieser Schleifkontakt 612 weist eine hohe Schichtdicke auf, dabei kann mittels des dreidimensionalen Druckens die Schichtdicke des Schleifkontaktes 612 effektiv und direkt eingestellt werden.

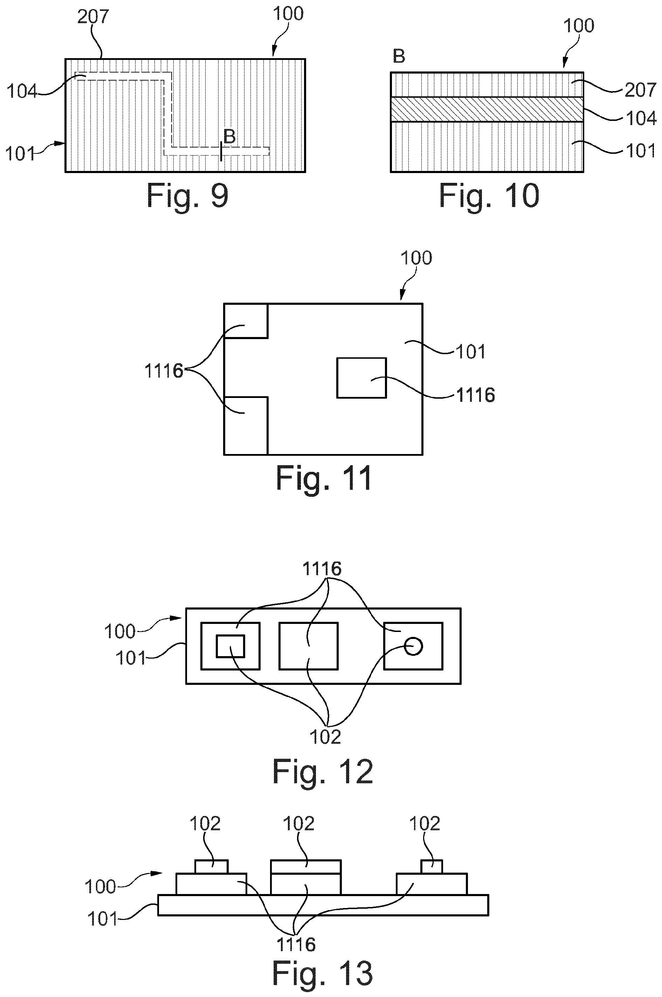

Im Folgenden unter Bezugnahme auf **Fig. 9** wird ein Komponententräger 100 dargestellt, welcher eine Einkapselung 207 aufweist. In dem Trägerkörper 101 des Komponententrägers 100 ist eine elektrisch leitende Schicht 104 angeordnet, welche als eine Leiterbahn ausgebildet ist. Die Einkapselung 207 umgibt zumindest eine Seite des Komponententrägers 100

Im Folgenden unter Bezugnahme auf **Fig. 10** wird ein Komponententräger 100 mit einer dreidimensionalen Struktur als Einkapselung 207 in einer anderen Ansicht dargestellt. Es wird ein Querschnitt B durch den Komponententräger 100 aus Fig. 9 gezeigt. Die Einkapselung 207 ist auf einer Oberfläche des Trägerkörpers 207 ausgebildet, sodass die Einkapselung 207 als Oberflächenschutz dienen kann. Unter der Einkapselung befindet sich die elektrisch leitenden Struktur 104, welche durch die Einkapselung 207 vor äußeren Einflüssen geschützt wird. Der Trägerkörper 101 kann aus einer Mehrschichtleiterplatte bestehen oder auch aus einer Einzelschichtleiterplatte. Die dreidimensional gedruckte Struktur bildet somit eine Oberfläche des Trägerkörpers aus, wobei Bereiche der Oberfläche sich in ihrer Härte, Rauigkeit und/oder Elastizität unterscheiden können. Je nach dem welches Material bei der dreidimensionalen Struktur (Einkapselung 207) verwendet wird, kann es unterschiedliche Eigenschaften besitzen. Eine entsprechend aufgeraute Oberfläche der dreidimensionalen Struktur (der Einkapselung 207) kann eine höhere Wärmeabfuhr gewährleisten als eine glatte Oberfläche.

Insbesondere kann ein und dieselbe Oberfläche verschiedene Bereiche aufweisen, welche zum Beispiel unterschiedliche Rauigkeiten haben. Dabei kann ein Bereich der Oberfläche der dreidimensionalen Struktur (Einkapselung 207), welcher über einer elektrisch leitenden Schichtstruktur 104 angeordnet ist eine höhere Rauigkeit als umliegende Bereiche der Oberfläche der dreidimensionalen Struktur (der Einkapselung 207) aufweisen, um mittels einer hohen Rauigkeit produzierte Wärme von der elektrisch leitenden Schichtstruktur 104 abzuleiten. Ferner kann die Oberfläche der dreidimensional gedruckten Struktur (der Einkapselung 207) über der elektrisch leitenden Schichtstruktur ein anderes Material aufweisen, um die darunter liegenden Strukturen besser vor äußeren mechanischen Einflüssen zu schützen.

Im Folgenden unter Bezugnahme auf **Fig. 11** wird ein Komponententräger 100 gemäß einem nicht zur Erfindung gehörenden Vergleichsbeispiel dargestellt, welcher auf zumindest einem Teil des Trägerkörpers 101 Aluminiumschichten 1116 aufweist. Insbesondere sind in Fig. 11 drei Bereiche des Trägerkörpers 101 von Aluminiumschichten 1116 bedeckt. Die Aluminiumschicht 1116 wird direkt auf den Trägerkörper 101 aufgedruckt. Die verschiedenen Aluminiumschichten 1116 können verschiedene Schichtdicken aufweisen, sodass jede Aluminiumschicht 1116 eine andere Dicke besitzt. Die Aluminiumschicht 1116 kann an jeder Position auf/in dem Trägerkörper 101 angebracht werden.

Im Folgenden unter Bezugnahme auf **Fig. 12** wird ein Komponententräger 100 mit drei Aluminiumschichten 1116 dargestellt, wobei die Aluminiumschichten jeweils mit Kupferschicht 102 bedeckt sind. Sowohl die Aluminiumschicht 1116 als auch die Kupferschicht 102 sind mittels des 3D Druckens herstellbar. Da Aluminium schwer lötbar ist, ist es von Vorteil, wenn leitende Schichten, wie die Kupferschichten 102, direkt auf das Aluminium aufgedruckt werden. Die Kupferschicht 102 kann verschiedene Formen aufweisen, wie eine rechteckige Form zum Ausbilden eines Batterieanschlusses, oder auch eine runde Form zum Ausbilden eines Pins für elektronische Komponenten. Ferner kann die Kupferschicht 102 die Aluminiumschicht 1116 komplett bedecken, um großflächige elektrisch leitende Kontakte bereitzustellen.

Im Folgenden unter Bezugnahme auf **Fig. 13** wird der Komponententräger 100 mit drei Aluminiumschichten 1116 und darauf angebrachten Kupferschichten 102 in einer Seitenansicht dargestellt. Es ist ersichtlich, dass zwei der drei Aluminiumschichten 1116 nicht vollständig von der Kupferschicht 102 bedeckt sind, eine hingegen ist vollständig von der Kupferschicht 102 bedeckt.

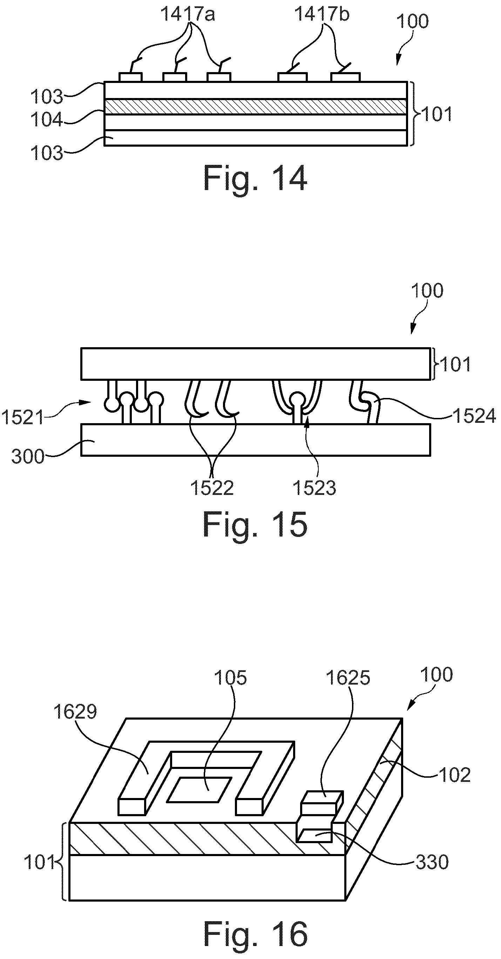

Im Folgenden unter Bezugnahme auf **Fig. 14** wird die dreidimensional gedruckte Struktur zumindest teilweise als elektrisch leitendendes Verbindungselement, insbesondere ein Federkontakt, ausgebildet. Der Federkontakt kann direkt auf den Trägerkörper 101 aufgedruckt werden. In Fig. 14 sind zwei verschiedene Federn 1417a, 1417b dargestellt, welche sich in ihrer Form unterscheiden. Die Federn 1417a, 1417b dienen als flexible elektrische Kontakte sodass Bewegungen an den Kontakten 1417a, 1417b und/oder an dem Komponententräger 101 abgefangen werden können und die Federkontakte 1417a, 1417b durch die Bewegung in ihrer Signalweiterleitung nicht beeinträchtigt werden. Ferner kann die dreidimensional gedruckte Struktur als ein Dämpfungselement, insbesondere als eine Feder 1417a, 1417b, ausgebildet sein, wobei das Dämpfungselement 1417a, 1417b nicht elektrisch leitend ist, sondern lediglich als ein Element zum Aufnehmen von mechanischen Schwingungen dient.

Im Folgenden unter Bezugnahme auf **Fig. 15** ist die dreidimensional gedruckte Struktur als ein mechanisches Verbindungselement 1521, 1522, 1523, 1524 dargestellt, welches insbesondere als eine Schnappverbindung 1523, eine Klettverbindung 1522, eine Reißverschlussverbindung 1521, eine Führungsschiene und/oder ein Führungspin 1524 ausgebildet ist. Das mechanische Verbindungselement 1521, 1522, 1523, 1524 ist eingerichtet eine lösbare Verbindung auszubilden. Alle oben genannten Verbindungselemente 1521, 1522, 1523, 1524 können dazu eingerichtet sein elektrisch leitende Verbindungen bereitzustellen. Die Klettverschlussverbindung 1522 kann beispielsweise dazu verwendet werden den Trägerkörper 101 an korrespondierenden Klettverschlussverbindungen an Textilelementen zu befestigen. Mittels der Schnappverbindung 1523 (oder auch Klemmverbindung) kann der Komponententräger 100 von einer Seite an einen weiteren Komponententräger 300 befestigt werden. Die mechanischen Verbindungselemente 1521, 1522, 1523, 1524 können dazu verwendet werden den Komponententräger 100 mit einem weiteren Komponententräger 300 zu verbinden, sodass zwischen zwei verschiedenen Komponententrägern 100, 300 zumindest mechanische und/oder elektrische Verbindungen hergestellt werden können. Die mechanischen Verbindungselemente 1521, 1522, 1523, 1524 können ferner dazu verwendet werden den Komponententräger 100 mit einer anderen Vorrichtung zu verbinden, an ein Modul zu befestigen, zu einer elektronischen Komponente zu verbinden oder diesen in ein Gehäuse einzubringen und lösbar zu befestigen.

Im Folgenden unter Bezugnahme auf **Fig. 16** wird die dreidimensional gedruckte Struktur als eine Verstärkungsstruktur 1625 dargestellt, insbesondere eine Verstärkungsstruktur der elektrisch leitfähigen Schichtstrukturen und/oder elektrisch isolierenden Schichtstrukturen. Oder als eine wärmeleitende Struktur 1629 dargestellt. Auf dem Trägerkörper 101 ist eine Komponente 105 angeordnet, welche von der wärmeleitenden Struktur 1629 umschlossen ist. Die wärmeleitende Struktur 1629 umgibt die Komponente 105 auf zumindest einer Seite. Es ist auch möglich, dass die wärmeleitende Struktur 1629 die Komponente 105 vollständig umschließt. Mittels der wärmeleitenden Struktur 1629 wird die Wärme, welche von der Komponente 105 erzeugt wird, abgeleitet, sodass die Komponente 105 vor einem Überhitzen und somit vor Beschädigungen bewahrt wird. Die wärmeableitende Struktur 1629 kann direkt auf dem Trägerkörper 101 aufgedruckt werden oder auch in den Trägerkörper 101 gedruckt werden. Als wärmeableitende Struktur kann auch die Kupferschicht 102 dienen, auf welcher Komponenten aufgebracht (aufgedruckt) werden können. Die wärmeableitende Struktur 1629 kann verschiedene Formen aufweisen. In Fig. 16 weist die wärmeableitende Struktur 1629 eine rechteckige Form auf, eine ovale oder runde Form ist ebenfalls möglich. Ferner weist der Trägerkörper 101 eine Ausnehmung 330 auf. An zumindest einer Seite der Ausnehmung 330 auf der Oberfläche des Trägerkörpers ist eine dreidimensional gedruckte Verstärkung 1625 aufgebracht. Die Verstärkung 1625 erhöht die Stabilität der Ausnehmung 330. Die Verstärkung 1625 kann auch um die Komponente 105 angeordnet werden, um somit die Komponente 105 von zumindest einer Seite vor Einwirkungen zu schützen. Die Verstärkung 1625 in Fig. 16 weist eine rechteckige Form auf, andere Formen (rund, oval, trapezförmig) sind ebenfalls anwendbar.

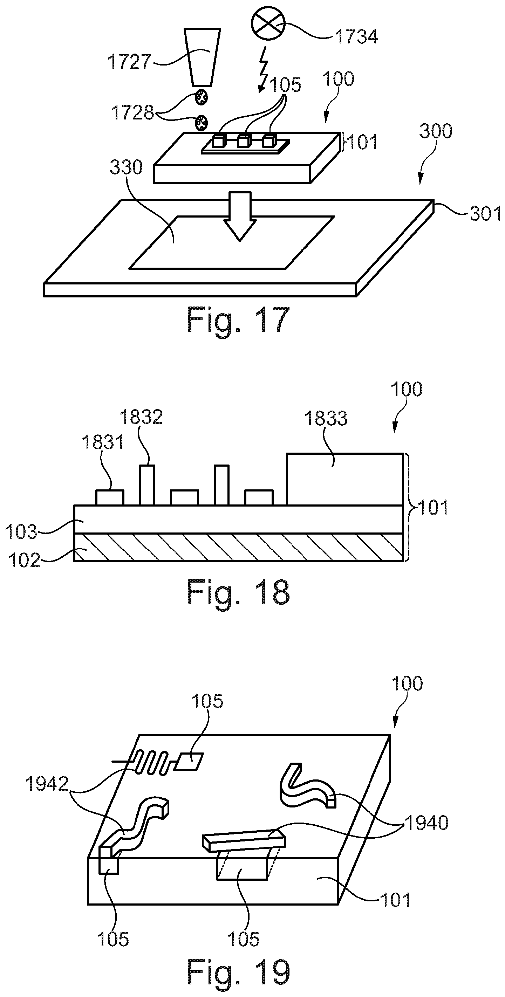

Im Folgenden unter Bezugnahme auf **Fig. 17** wird ein Verfahren zum Herstellen eines Komponententrägers 100 dargestellt, wobei zumindest ein Teil des Komponententrägers 100 als eine dreidimensional gedruckte Struktur ausgebildet ist. Ein weiterer Komponententräger 300 ist dargestellt, wobei der weitere Komponententräger 300 mit dem gleichen Herstellungsverfahren erzeugt werden kann. Der Komponententräger 100 wird direkt auf und/oder in den weiteren Komponententräger 300 aufgedruckt. Der weitere Komponententräger 300 stellt eine Oberfläche bereit auf/in welcher der Komponententräger 100 mittels 3D Druckens ausgebildet wird. Der weitere Komponententräger 300 weist eine Ausnehmung 330 auf, in welche der Komponententräger 100 gedruckt werden kann. Eine Verarbeitungsvorrichtung, wie ein Druckkopf 1727 (welcher auch eine Materialzuführdüse sein kann) weist ein druckbares Material 1728 auf. Das druckbare Material 1728 wird mittels des Druckkopfes 1727 ausgegeben, so dass es eine dreidimensional gedruckte Struktur des Komponententrägers 100 formen kann. Somit wird der Komponententräger 100 auf und/oder in dem weiteren Komponententräger 300 dreidimensional gedruckt unter Verwendung des druckbaren Materials 1728. Ferner kann eine Behandlungsvorrichtung 1734, wie eine Laservorrichtung, vorgesehen sein, welche einen Laserstrahl ausstrahlt zum Behandeln des druckbaren Materials 1728. Das druckbare Material 1728, wie z.B. Pulvermaterial, kann damit geschmolzen oder gesintert werden um eine verfestigte dreidimensional gedruckte Struktur auszubilden. Es ist ebenfalls möglich, dass der Druckkopf 1727 als Extruder fungiert, so dass geschmolzenes druckbares Material 1728 an einer gewünschten Position ausgegeben wird, wobei das druckbare Material 1728 von selbst aushärten kann.

Im Folgenden unter Bezugnahme auf **Fig. 18** wird die dreidimensional gedruckte Struktur 1831, 1832, 1833 in verschiedenen Variationen dargestellt. Zum einen ist die dreidimensional gedruckte Struktur 1831 als Anschlusspad (oder auch Lötpad) ausgebildet. Zum anderen ist die dreidimensional gedruckte Struktur 1832 als Pin ausgebildet. Ferner ist die dreidimensional gedruckte Struktur 1833 als leitende Verstärkungsstruktur ausgebildet.

Die Anschlusspads 1831 und/oder Pins 1832 sind aus Kupfer gedruckt. Die dreidimensional gedruckte Struktur kann ferner auch die Kupferschicht 102 ausbilden, welche als elektrisch leitende Schicht und/oder als wärmeableitende Schicht fungieren kann.

Im Folgenden unter Bezugnahme auf **Fig. 19** wird die dreidimensional gedruckte Struktur als eine Antennenstruktur 1942 dargestellt. Die Antennenstruktur 1942 ist derart ausgebildet, dass die Antennenstruktur 1942 direkt auf und/oder in den Trägerkörper 101 aufdruckbar ist. Die Antennenstruktur kann dabei mit verschiedenen Dicken auf den Trägerkörper 101 aufgedruckt werden, je nach gewünschter Empfangs- bzw. Sendestärke der Antennenstruktur 1942. Die Antennenstruktur 1942 ist mit einer Komponente 105 gekoppelt, sodass die Komponente 105 als Sender und/oder Empfänger von Antennensignalen dienen kann. Ferner kann die Komponente 105 als Sensor zum Messen von Frequenzen ausgebildet sein. Antennenstruktur 1942 ist dabei mit Komponenten 105 gekoppelt, welche auf und/oder in dem Trägerkörper 101 angeordnet sind. Ferner ist die dreidimensional gedruckte Struktur als eine Verstärkungsstruktur, insbesondere als Glasfaser 1940, ausgebildet. Die Glasfasern 1940 dienen dazu steife Bereiche auf einem flexiblen Trägerkörper 101 herzustellen. Die Glasfasern 1940 sind sowohl direkt auf (d.h. über) Komponenten 105 anordbar als auch direkt auf dem Trägerkörper 101 um elektrisch leitende und/oder elektrisch isolierende Schichtstrukturen zumindest teilweise zu versteifen.

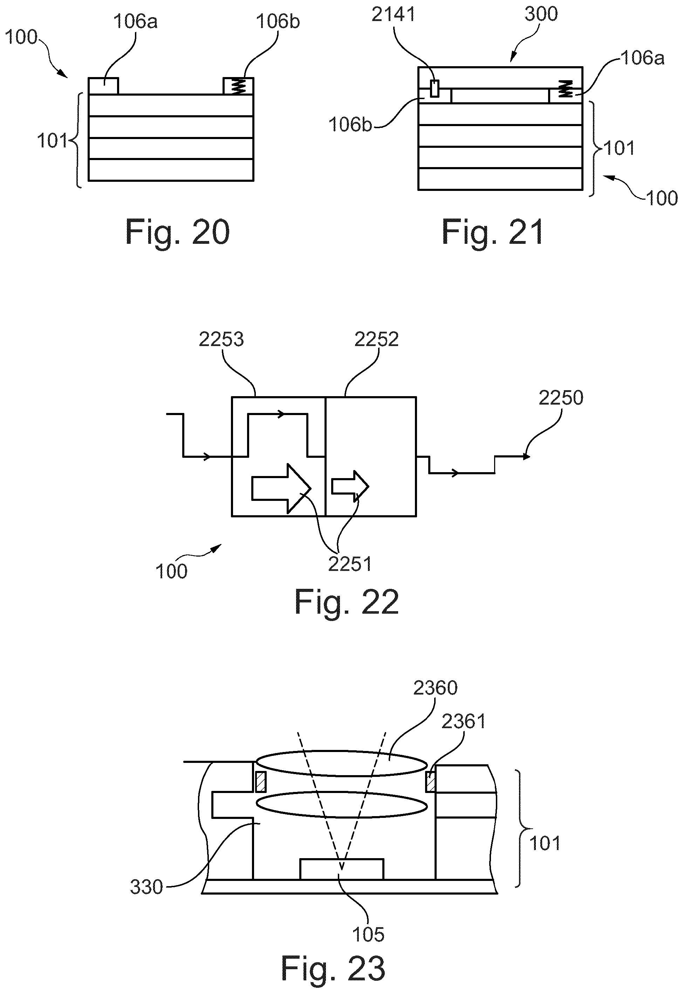

Im Folgenden unter Bezugnahme auf **Fig. 20** wird eine dreidimensional gedruckte Struktur als ein mechanisches Verbindungselement, insbesondere. als eine Gewindebuchse 106, dargestellt. Die Gewindebuchse 106b kann mit einem Gewinde versehen sein oder ohne ein Gewinde 106a verwendet werden. Das mechanische Verbindungselement 106a, b ist direkt auf zumindest einer der Mehrzahl von Schichtstrukturen des Trägerkörpers 101 aufgedruckt.

Im Folgenden unter Bezugnahme auf **Fig. 21** wird die dreidimensional gedruckte Struktur als ein mechanisches Verbindungselement 106a, b, insbesondere als eine Gewindebuchse 106, dargestellt, wobei das mechanische Verbindungselement 106a, b mittels eines Befestigungsmittels 2141 den Komponententräger 100 mit einem weiteren Komponententräger 300 verbindet. Das mechanische Verbindungselement 106a, b kann den Komponententräger 100 auch mit anderen Vorrichtungen oder zu einem Gehäuse verbinden. Als Befestigungsmittel 2141 können Schrauben oder auch Bolzen verwendet werden.

Im Folgenden unter Bezugnahme auf **Fig. 22** wird eine weitere dreidimensionale Struktur 2253 als ein weiterer Teil des Komponententrägers ausgebildet, wobei die dreidimensionale Struktur 2252 und die weitere dreidimensionale Struktur 2253 aus unterschiedlichen Materialien bestehen. Insbesondere bestehen die die dreidimensionale Struktur 2252 und die weitere dreidimensionale Struktur 2253 aus Materialien mit unterschiedlicher Wärmeleitfähigkeit und/oder Stromleitfähigkeit. Ferner weist die eine dreidimensional gedruckte Struktur 2252 eine höhere Wärmeleitfähigkeit und/oder Stromleitfähigkeit als die weitere dreidimensionale Struktur 2253 auf. Die unterschiedliche Wärmeleitfähigkeit der dreidimensional gedruckten Strukturen 2252, 2253 ist in Fig. 22 mit Pfeilen 2251 gekennzeichnet. Die Stromleitfähigkeit ist mittels eines durch die dreidimensional gedruckten Strukturen 2252, 2253 verlaufenden elektrischen Signales 2250 dargestellt. Sowohl die Wärme 2251 als auch die Stärke des elektrischen Signales 2250 sind unterschiedlich in den entsprechenden dreidimensional gedruckten Strukturen 2252, 2253. Ferner kann die dreidimensional gedruckte Struktur und/oder die weitere dreidimensional gedruckte Struktur aus elektrisch leitenden Materialien, insbesondere Aluminium mit Kupfer, ausgebildet sein. Aluminium besitzt eine Wärmeleitfähigkeit kleiner als die Wärmeleitfähigkeit von Kupfer, sodass eine dreidimensional gedruckte Struktur aus Aluminium/Kupfer ein guter Wärmeleiter ist aber schlechter als nur Kupfer und auch ebenso ein guter elektrischer Leiter. Werden die dreidimensional gedruckte Struktur 2252 und die weitere dreidimensional gedruckte Struktur 2253 übereinander ausgebildet, formen sie eine Bimetallelement.

Im Folgenden unter Bezugnahme auf **Fig. 23** wird gemäß einem nicht zur Erfindung gehörenden Vergleichsbeispiel die dreidimensional gedruckte Struktur ausgebildet als zumindest ein Element, welches ausgewählt ist aus der Gruppe bestehend aus einem optischem Element, einem Lichtdetektor, einem Lichtemitter, einer Linse 2360, einer Mikrolinse. In dem Trägerkörper 101 wird eine Ausnehmung 330 erzeugt, innerhalb welcher dreidimensional gedruckte Linse 2360 angeordnet wird. Die Linse 2360 wird über einer Komponente 105 angeordnet, wobei die Komponente 105 innerhalb, bevorzugt am Boden, der Ausnehmung 330 angeordnet ist. Die Komponente 105 kann ein Lichtemitter oder ein Lichtdetektor sein, welcher durch die Linse 2360 entsprechende Lichtwellen emittiert oder detektiert. Ferner kann die Linse 2360 zusätzlich zumindest einen Piezokristall 2361 aufweisen, welcher zum Fokussieren der Linse 2360 dient.

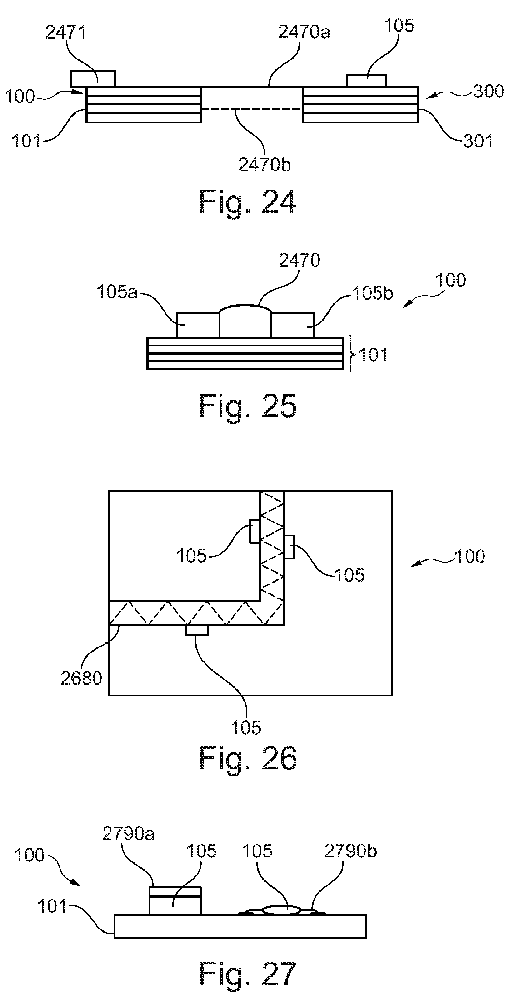

Im Folgenden unter Bezugnahme auf **Fig. 24** wird die dreidimensional gedruckte Struktur als ein elektrischer Kontakt 2471, insbesondere einem USB-Kontakt und/oder einem QFN-Kontakt dargestellt. Der elektrische Kontakt 2471 kann an einer Seite des Komponententrägers 100 angeordnet sein, sodass z.B. mittels eines USB-Sticks einfach ein Kontakt zu dem elektrischen Kontakt (USB-Kontakt) 2471 hergestellt werden kann. Ferner kann die dreidimensional gedruckte Struktur die Komponente 105 ausbilden, welche Komponente 105 insbesondere ein aktives oder passives Bauelement ist. Weiterhin ist die dreidimensional gedruckte Struktur als eine Bruchsicherung 2470 ausgebildet. Die Bruchsicherung verbindet beispielsweise zwei verschiedene Komponententräger 100 und 300 miteinander und kann diese bei Bedarf trennen. Die Bruchsicherung 2470a kann an einer Oberfläche der Komponententräger 100, 300 angebracht werden. Ferner kann die Bruchsicherung 2470b auch an zumindest einer der Mehrzahl von Schichtstrukturen der jeweiligen Komponententräger 100, 300 ausgebildet werden. Die Bruchsicherung 2470 kann eine elektrisch leitende Schichtstruktur der Komponententräger 100, 300 sein, sodass eine elektrisch leitende Verbindung herstellbar ist.

Weiterhin kann die dreidimensional gedruckte Struktur als eine starre und/oder flexible Struktur ausgebildet sein, sodass die Bruchsicherung 2470 entweder starr und damit leicht zu brechen ist oder die Bruchsicherung 2470 eine gewisse Flexibilität aufweist und erst bei einer bestimmten Beanspruchung bricht.

Im Folgenden unter Bezugnahme auf **Fig. 25** wird ein Komponententräger 100 dargestellt wobei die dreidimensional gedruckte Struktur eine Bruchsicherung 2470 ist. Die Bruchsicherung 2470 verbindet zwei Komponenten 105a und 105b auf ein und demselben Komponententräger 100. Die Bruchsicherung kann dabei als elektrischer Leiter fungieren, welcher beispielsweise bei zu hoher Spannung oder zu hohem Strom als Sicherheitsfunktion bricht.

Im Folgenden unter Bezugnahme auf **Fig. 26** wird gemäß einem nicht zur Erfindung gehörenden Vergleichsbeispiel die dreidimensional gedruckte Struktur als ein Wellenleiter 2680 dargestellt. Der Wellenleiter 2680 kann direkt auf und/oder in dem Komponententräger 100 aufgedruckt werden. An dem Wellenleiter 2680 ist zumindest eine Komponente 105 angeordnet, bevorzugter Weise ist eine Mehrzahl von Komponenten 105 angeordnet. Die Komponenten 105 dienen dabei als Sensoren (Detektoren) um beispielsweise den Verlauf oder die Intensität der Lichtwellen innerhalb des Leiters zu detektieren oder auch zu überwachen.

Im Folgenden unter Bezugnahme auf **Fig. 27** wird ein Komponententräger dargestellt, wobei die dreidimensional gedruckte Struktur zumindest einen Teil 2790a,b einer Komponente 105 ausbildet. Die dreidimensional gedruckte Struktur kann direkt auf die Komponente aufgedruckt werden und somit einen Teil der Komponente 2970a ausbilden. Dabei kann die dreidimensional gedruckte Struktur zur Wärmeableitung, z.B. als Wärmesenke mit Finnen, dienen. Ferner kann die dreidimensional gedruckte Struktur als Teil einer Komponente 2790b ausgebildet sein, welcher die Komponente 105 mit dem Trägerkörper 101 verbindet, umso elektrisch leitende Strukturen zur Signalweiterleitung auszubilden. Ferner kann die dreidimensional gedruckte Struktur auch die Komponente 105 selbst vollständig ausbilden.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden ist, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Bezugszeichenliste:

- 100, 300: Komponententräger
- 101, 301: Trägerkörper
- 102: Kupferschicht
- 103: elektrisch isolierende Schicht
- 104: elektrisch leitende Schicht
- 105: Komponente
- 106: Verbindungselement
- 207: Einkapselung
- 330: Ausnehmung
- 408: Pins
- 409: Kontakte
- 410: Anschlusspads
- 511: Lötdepot
- 612: Schleifkontakt
- 713: Material A
- 714: Material B
- 715: Material C
- 1116: Aluminiumschicht
- 1417: Dämpfungselement
- 1521: Reißverschlusselemente
- 1522: Klettelemente
- 1523: Klemmelemente
- 1524: Ankerelemente
- 1625: Verstärkung
- 1626: Ausnehmung
- 1629: wärmeleitende Struktur
- 1727: Druckkopf
- 1728: druckbares Material
- 1734: Behandlungsvorrichtung
- 1831, 1832, 1833: dreidimensional gedruckte Struktur
- 1940: Glasfaser
- 1942: Antennenstruktur
- 2141: Befestigungselement
- 2250: elektrisches Signal
- 2251: Wärme
- 2252: dreidimensional gedruckte Struktur
- 2253: weitere dreidimensional gedruckte Struktur
- 2360: Linse
- 2361: Piezokristall
- 2470: Brücke
- 2471: elektrischer Kontakt
- 2680: Wellenleiter
- 2790: Teil einer Komponente
- R: Stapelrichtung

## Patentansprüche

1. Komponententräger (100, 300), wobei der Komponententräger (100, 300) aufweist:
einen Trägerkörper (101, 301), aufweisend eine Mehrzahl von elektrisch leitfähigen Schichtstrukturen (104) und/oder elektrisch isolierenden Schichtstrukturen (103);
wobei zumindest ein Teil des Komponententrägers (100, 300) als dreidimensional gedruckte Struktur (1831, 1832, 1833, 2252) ausgebildet ist, **dadurch gekennzeichnet, dass**
zumindest eine der Mehrzahl von elektrisch leitfähigen Schichtstrukturen (104) zumindest eines aus der Gruppe aufweist, die aus Aluminium, Nickel, Silber, Gold, Palladium, und Wolfram besteht;
die dreidimensional gedruckte Struktur (1831, 1832, 1833, 2252) Kupfer aufweist und auf der zumindest einen der Mehrzahl von elektrisch leitfähigen Schichtstrukturen (104) gedruckt ist, die zumindest eines aus der Gruppe aufweist, die aus Aluminium, Nickel, Silber, Gold, Palladium, und Wolfram besteht; und
die dreidimensional gedruckte Struktur (1831, 1832, 1833, 2252) mittels zumindest einem aus einer Gruppe bestehend aus Selektiven Laser Schmelzen, Selektiven Laser Sintern und Elektronenstrahlschmelzen geformt ist.

2. Komponententräger (100, 300) gemäß Anspruch 1, wobei
die dreidimensional gedruckte Struktur (1831, 1832, 1833, 2252) eines von Folgendem ist:
ein Pin, ein Mikropin, eine Buchse, ein ringförmiger Schleifkontakt, eine Gewindebuchse, eine Klettverbindung, eine Reißverschlussverbindung, ein Bimetall, eine Bruchsicherung, ein USB-Kontakt, ein QFN-Kontakt, ein magnetischer Sensor, eine Linse, eine Mikrolinse, ein Wellenleiter, eine Energiegewinnungseinheit, ein optoelektrischer Wandler, ein Spannungswandler, eine kryptografische Komponente, ein Akkumulator oder eine Kamera.

3. Komponententräger (100, 300) gemäß einem der vorherigen Ansprüche, wobei die dreidimensional gedruckte Struktur (1831, 1832, 1833, 2252) gemäß einer der folgenden Ausführungsformen ausgebildet ist:
3.i) die dreidimensional gedruckte Struktur (1831, 1832, 1833, 2252) ist im Inneren und/oder an einer Oberfläche des Trägerkörpers (101, 301) geformt;
3.ii) die dreidimensional gedruckte Struktur (1831, 1832, 1833, 2252) ist entlang einer Stapelrichtung (R) der Mehrzahl von Schichtstrukturen geformt;.
3.iii) die dreidimensional gedruckte Struktur (1831, 1832, 1833, 2252) ist senkrecht zu einer Stapelrichtung (R) der Mehrzahl von Schichtstrukturen geformt;
wobei in der Ausführungsform 3.iii) vorzugsweise die dreidimensional gedruckte Struktur (1831, 1832, 1833, 2252) unterschiedliche Querschnittsflächen aufweist, weiter insbesondere in einer Stapelrichtung (R) der Mehrzahl von Schichtstrukturen und/ oder senkrecht zu einer Stapelrichtung (R) der Mehrzahl von Schichtstrukturen.

4. Komponententräger (100, 300) gemäß einem der vorherigen Ansprüche, wobei der Komponententräger einen umgebenden Komponententrägerbereich und einen umgebenen Komponententrägerbereich aufweist, der von dem umgebenden Komponententrägerbereich umgeben ist, wobei insbesondere zumindest ein Teil des umgebenden Komponententrägerbereich und/oder des umgebenen Komponententrägerbereich als weitere dreidimensional gedruckte Struktur (2253) ausbildbar ist.

5. Komponententräger (100, 300) gemäß einem der vorherigen Ansprüche, wobei die dreidimensional gedruckte Struktur (1831, 1832, 1833, 2252) gemäß einer der folgenden Ausführungsformen ausgebildet ist:
5.i) die dreidimensional gedruckte Struktur (1831, 1832, 1833, 2252) bildet zumindest teilweise die elektrisch leitfähigen Schichtstrukturen (104) und/oder elektrisch isolierenden Schichtstrukturen (103) aus;
5.ii) die dreidimensional gedruckte Struktur (1831, 1832, 1833, 2252) ist als eine starre und/oder flexible Struktur ausgebildet.

6. Komponententräger (100, 300) gemäß einem der vorherigen Ansprüche, wobei Komponententräger (100, 300) gemäß einer der folgenden Ausführungsformen ausgebildet ist:
6.i) der Trägerkörper (101, 301) weist eine Ausnehmung (330, 1626) auf, wobei die dreidimensional gedruckte Struktur (1831, 1832, 1833, 2252) innerhalb der Ausnehmung (330, 1626) gedruckt wird;
6.ii) zumindest ein Teil des Trägerkörpers (101, 301) ist mittels der dreidimensional gedruckten Struktur (1831, 1832, 1833, 2252) als Einkapselung (207) zumindest teilweise eingekapselt, wobei die Einkapselung (207) eine Stahl- und/oder Titanverkapselung ist.

7. Komponententräger (100, 300) gemäß einem der vorherigen Ansprüche, wobei die dreidimensional gedruckte Struktur (1831, 1832, 1833, 2252) gemäß einer der folgenden Ausführungsformen ausgebildet ist:
7.i) die dreidimensional gedruckte Struktur (1831, 1832, 1833, 2252) ist zumindest teilweise als elektrisch leitendendes Verbindungselement (106), insbesondere als ein Anschlusspad (410), ein Pin (408), eine Buchse, ein Mikropin, ein, insbesondere ringförmiger, Schleifkontakt (612) und/oder ein Federkontakt ausgebildet;
wobei in der Ausführungsform 7i) vorzugsweise auf das leitende Verbindungselement (106) ein Lötdepot (511) aufbringbar ist, insbesondere als dreidimensional gedruckte Struktur (1831, 1832, 1833, 2252);
7.ii) die dreidimensional gedruckte Struktur (1831, 1832, 1833, 2252) ist als ein Dämpfungselement, insbesondere als eine Feder (1417a, 1417b), ausgebildet;
7.iii) die dreidimensional gedruckte Struktur (1831, 1832, 1833, 2252) ist als ein mechanisches Verbindungselement (106), insbesondere eine Gewindebuchse (106), eine Schnappverbindung (1523), eine Klettverbindung (1522, 1523), eine Reißverschlussverbindung (1521), eine Führungsschiene und/oder ein Führungspin (1524), ausgebildet;
wobei in der Ausführungsform 7.iii) vorzugsweise das mechanische Verbindungselement (106) eingerichtet ist, eine lösbare Verbindung auszubilden;
7.iv) die dreidimensional gedruckte Struktur (1831, 1832, 1833, 2252) ist eine wärmeleitende Struktur (1629);
7.v) die dreidimensional gedruckte Struktur (1831, 1832, 1833, 2252) weist zumindest eine Materialkomponente auf, welche ausgewählt ist aus der Gruppe bestehend aus Kupfer, Aluminium, Stahl, Titan, Metalllegierung, Kunststoff und Fotolack;
7.vi) die dreidimensional gedruckte Struktur (1831, 1832, 1833, 2252) ist eine Antennenstruktur (1942),
wobei in der Ausführungsform 7.vi) vorzugsweise die Antennenstruktur (1942) derart ausgebildet ist, dass die Antennenstruktur (1942) direkt auf und/oder in den Trägerkörper (101, 301) aufdruckbar ist;
7.vii) die dreidimensional gedruckte Struktur (1831, 1832, 1833, 2252) bildet eine Verstärkungsstruktur aus, insbesondere eine Verstärkungsstruktur (1625) der elektrisch leitfähigen Schichtstrukturen (104) und/oder elektrisch isolierenden Schichtstrukturen (103);
7.viii) die dreidimensional gedruckte Struktur (1831, 1832, 1833, 2252) bildet eine Oberfläche des Trägerkörpers (101, 301) aus, wobei Bereiche der Oberfläche sich in ihrer Härte, Rauigkeit und/oder Elastizität unterscheiden;
wobei in der Ausführungsform 7.ii) vorzugsweise zumindest ein Bereich der dreidimensional gedruckten Struktur (1831, 1832, 1833, 2252) aus Stahl und/oder Titan ausgebildet ist;
und/oder wobei in der Ausführungsform 7.ii) vorzugsweise die dreidimensional gedruckte Struktur (1831, 1832, 1833, 2252) zumindest einen Teil einer Komponente ausbildet.

8. Komponententräger (100, 300) gemäß einem der vorherigen Ansprüche, wobei der Komponententräger (100, 300) gemäß einer der folgenden Ausführungsformen ausgebildet ist:
8.i) der Komponententräger (100, 300) weist ferner eine Komponente auf, insbesondere eine elektronische Komponente, oberflächenmontiert an und/ oder eingebettet in zumindest einer von der Mehrzahl von elektrisch leitfähigen Schichtstrukturen (104) und/oder elektrisch isolierenden Schichtstrukturen (103);
wobei vorzugsweise in der Ausführungsform 8.i) die Komponente ausgewählt aus einer Gruppe ist, welche besteht aus einer elektronischen Komponente, einem elektrisch nicht leitfähigem und/ oder elektrisch leitfähigem Inlay, einer Wärmeübertragungseinheit, einem Lichtführungselement, einer Energiegewinnungseinheit, einer aktiven elektronischen Komponente, einer passiven elektronischen Komponente, einem elektronischen Chip, einer Datenspeichervorrichtung, einem Filter, einem integrierten Schaltkreis, einer Signalverarbeitungskomponente, einer Leistungsmanagementkomponente, einem optoelektrischen Wandler, einem Spannungswandler, einer kryptografischen Komponente, einer Sende- und/ oder Empfangseinheit, einem elektromechanischen Wandler, einem Aktuator, einem mikroelektromechanischen System, einem Mikroprozessor, einer Kapazität, einem Widerstand, einer Induktivität, einem Akkumulator, einem Schalter, einer Kamera, einer Antenne (1942), einem magnetischen Element, einem weiteren Komponententräger (100, 300) und einem Logik Chip;
8.ii) die dreidimensional gedruckte Struktur (1831, 1832, 1833, 2252) ist derart ausgebildet, dass auf sie eine weitere dreidimensional gedruckte Struktur (2253) aufdruckbar ist;
8.iii) ein weiterer Teil des Komponententrägers (100, 300) ist als weitere dreidimensional gedruckte Struktur (2253) ausgebildet, wobei die dreidimensional gedruckte Struktur (1831, 1832, 1833, 2252) und die weitere dreidimensional gedruckte Struktur (2253) aus unterschiedlichen Materialien bestehen;
wobei vorzugsweise in der Ausführungsform 8.iii):
8.iii.1) die eine dreidimensional gedruckte Struktur (1831, 1832, 1833, 2252) eine höhere Wärmeleitfähigkeit (1629) und/oder Stromleitfähigkeit als die weitere dreidimensional gedruckte Struktur (2253) aufweist, oder
8.iii.2) die dreidimensional gedruckte Struktur (1831, 1832, 1833, 2252) und/oder die weitere dreidimensional gedruckte Struktur (2253) aus einem elektrisch leitenden Material, insbesondere Aluminium, ausgebildet ist,
und/oder wobei vorzugsweise in der Ausführungsform 8.iii) die dreidimensional gedruckte Struktur (1831, 1832, 1833, 2252) und die weitere dreidimensional gedruckte Struktur (2253) übereinander ausgebildet sind zum Ausbilden eines Bimetallelementes.

9. Komponententräger (100, 300) gemäß einem der vorherigen Ansprüche, wobei die dreidimensional gedruckte Struktur (1831, 1832, 1833, 2252) gemäß einer der folgenden Ausführungsformen ausgebildet ist:
9.i) die dreidimensional gedruckte Struktur (1831, 1832, 1833, 2252) ist ausgebildet als zumindest eines aus einer Gruppe bestehend aus einem aktiven oder passiven elektronischen Bauelement, einem Widerstand, einem Kondensator, eine Spule, einem elektrischem Kontakt (409, 2471), einer Bruchsicherung, einem USB-Kontakt und einem QFN-Kontakt;
9.ii) die dreidimensional gedruckte Struktur (1831, 1832, 1833, 2252) ist ausgebildet als zumindest eines aus einer Gruppe bestehend aus einem Sensor, einem Aktuator, einem magnetischen Sensor, EMV Schirmung und einem mikroelektromechanischen System;
9.iii) die dreidimensional gedruckte Struktur (1831, 1832, 1833, 2252) ist ausgebildet als zumindest ein Element, welches ausgewählt ist aus der Gruppe bestehend aus einem optischem Element, einem Lichtdetektor, einem Lichtemitter, einer Linse (2360), einer Mikrolinse, einem Wellenleiter (2680);
9.iv) die dreidimensional gedruckte Struktur (1831, 1832, 1833, 2252) ist ausgebildet als zumindest ein Element, welches ausgewählt ist aus der Gruppe bestehend aus einem Mikrophon, einem Lautsprecher und einem Helmholtzhorn.

10. Komponententräger (100, 300) gemäß einem der vorherigen Ansprüche, wobei der Komponententräger (100, 300) gemäß einer der folgenden Ausführungsformen ausgebildet ist:
10.i) zumindest eine der Mehrzahl von elektrisch leitfähigen Schichtstrukturen (104) weist zumindest eines aus der Gruppe auf, die besteht aus Kupfer, Aluminium, Nickel, Silber, Gold, Palladium, und Wolfram, wobei eines der genannten Materialien optional mit hochleitfähigem Material wie Graphen beschichtet ist; und/oder
10.ii) zumindest eine von der Mehrzahl von elektrisch isolierenden Schichtstrukturen (103) weist zumindest eines von der Gruppe auf, die besteht aus Harz, insbesondere verstärktem oder nicht verstärktem Harz, beispielsweise Epoxidharz oder Bismaleimide-Triazin Harz, FR-4, FR-5, Zyanat Ester, Polyphenylen Derivate, Glass, Prepreg Material, Polyimid, Polyamid, flüssigkristallines Polymer, Epoxid basierten Aufbau Film, Polytetrafluorethylen, eine Keramik, und ein Metalloxid;
10.iii) der Komponententräger (100, 300) ist als eine Platte geformt;
10.iv) der Komponententräger (100, 300) ist konfiguriert als eines von der Gruppe, die besteht aus einer Leiterplatte und einem Substrat;
10.v) der Komponententräger (100, 300) ist als ein Laminat-Typ Komponententräger (100, 300) konfiguriert.

11. Komponententräger (100, 300) gemäß Anspruch 1, wobei
die dreidimensional gedruckte Struktur (1831, 1832, 1833, 2252) zumindest teilweise als elektrisch leitendendes Verbindungselement (106) ausgebildet ist, insbesondere als ein Anschlusspad (410), ein Pin (408) oder ein Mikropin; und
auf das leitende Verbindungselement (106) ein Lötdepot (511) als weitere dreidimensional gedruckte Struktur (1831, 1832, 1833, 2252) aufgebracht ist.

12. Komponententräger (100, 300) gemäß Anspruch 1, wobei die zumindest eine der Mehrzahl von elektrisch leitfähigen Schichtstrukturen (104), die zumindest eines aus der Gruppe aufweist, die aus Aluminium, Nickel, Silber, Gold, Palladium, und Wolfram besteht, eine weitere dreidimensional gedruckte Struktur (1116) ist.

13. Verfahren zum Herstellen eines Komponententrägers (100, 300) gemäß einem der vorherigen Ansprüche, wobei das Verfahren aufweist:
Verbinden einer Mehrzahl von elektrisch leitfähigen Schichtstrukturen (104) und/oder elektrisch isolierenden Schichtstrukturen (103) zum Bilden eines Trägerkörpers (101, 301);
Ausbilden von zumindest einem Teil des Komponententrägers (100, 300) als dreidimensional gedruckte Struktur (1831, 1832, 1833, 2252) mittels dreidimensionalen Druckens;
wobei die dreidimensional gedruckte Struktur (1831, 1832, 1833, 2252) mittels zumindest einem aus einer Gruppe bestehend aus Selektiven Laser Schmelzen, Selektiven Laser Sintern und Elektronenstrahlschmelzen geformt wird.

14. Das Verfahren gemäß Anspruch 13, wobei das dreidimensionale Drucken aufweist:
Einbringen eines druckbaren Materials in eine Verarbeitungsvorrichtung,
Schmelzen des druckbaren Materiales in der Verarbeitungsvorrichtung,
Zuführen des geschmolzenen druckbaren Materials auf und/ oder in den Trägerkörper (101, 301) zum Formen zumindest einer Schicht von zumindest einem Teil der dreidimensional gedruckten Struktur (1831, 1832, 1833, 2252); und/oder
Aufbringen eines druckbaren Materiales, insbesondere eines pulverförmigen Materials, auf und/ oder in den Trägerkörper (101, 301),
Verfestigen des aufgebrachten druckbaren Materiales zum Formen zumindest einer Schicht von zumindest einem Teil der dreidimensional gedruckte Struktur (1831, 1832, 1833, 2252);
wobei ferner vorzugsweise eine der folgenden Ausführungsformen implementiert wird:
14.i) bevor dem Verfestigen des druckbaren Materials wird das druckbare Material mittels einer thermischen Behandlungsvorrichtung, insbesondere einer Laservorrichtung, geschmolzen, und/oder
14.ii) das druckbare Material wird mittels einer Materialzuführdüse aufgebracht,
wobei in der Ausführungsform 14.ii) mehr bevorzugt das Verfahren ferner aufweist
Bewegen der Materialzuführdüse zum Formen einer weiteren Schicht von dem zumindest einen Teil der dreidimensional gedruckten Struktur (1831, 1832, 1833, 2252);
oder 14.iii) der Trägerkörper (101, 301) wird in einem Materialbett bereitgestellt, bevor das druckbare Material dem Trägerkörper (101, 301) zugeführt wird;
wobei in den Ausführungsformen 14.i) bis 14.iii) mehr bevorzugt das Verfahren ferner aufweist
Bewegen des Trägerkörpers (101, 301) zum Formen einer weiteren Schicht von dem zumindest einen Teil der dreidimensional gedruckten Struktur.

15. Das Verfahren gemäß Anspruch 13,
wobei das Verfahren ein Anordnen des Trägerkörpers (101, 301) in einem Behälter aufweist,
wobei das dreidimensionale Drucken aufweist:
Bereitstellen eines verfestigbaren Fluidmaterials in dem Behälter,
Verfestigen des Fluidmaterials mittels einer Behandlungsvorrichtung, insbesondere einer Laservorrichtung, auf und/ oder in dem Trägerkörper (101, 301) zum Formen zumindest einer Schicht von zumindest einem Teil der dreidimensional gedruckten Struktur (1831, 1832, 1833, 2252);
wobei insbesondere das Verfahren ferner aufweist
Bewegen des Trägerkörpers (101, 301) zum Formen einer weiteren Schicht von dem zumindest einem Teil der dreidimensional gedruckten Struktur (1831, 1832, 1833, 2252).

## Claims

1. A component carrier (100, 300), wherein the component carrier (100, 300) comprises:
a carrier body (101, 301) comprising a plurality of electrically conductive layer structures (104) and/or electrically insulating layer structures (103);
wherein at least a part of the component carrier (100, 300) is configured as a three-dimensionally printed structure (1831, 1832, 1833, 2252), **characterized in that**
at least one of the plurality of electrically conductive layer structures (104) comprises at least one of the group consisting of aluminum, nickel, silver, gold, palladium, and tungsten;
the three-dimensionally printed structure (1831, 1832, 1833, 2252) comprises copper and is printed on the at least one of the plurality of electrically conductive layer structures (104) comprising at least one of the group consisting of aluminum, nickel, silver, gold, palladium, and tungsten; and
the three-dimensionally printed structure (1831, 1832, 1833, 2252) is formed by at least one of a group consisting of selective laser melting, selective laser sintering, and electron beam melting.

2. The component carrier (100, 300) according to claim 1, wherein
the three-dimensionally printed structure (1831, 1832, 1833, 2252) is one of:
a pin, a micropin, a socket, an annular sliding contact, a threaded socket, a hook and loop connection, a zipper connection, a bimetal, an anti-break, a USB contact, a QFN contact, a magnetic sensor, a lens, a microlens, a waveguide, an energy harvesting unit, an optoelectric converter, a voltage converter, a cryptographic component, an accumulator, or a camera.

3. The component carrier (100, 300) according to one of the preceding claims, wherein the three-dimensionally printed structure (1831, 1832, 1833, 2252) is configured according to one of the following embodiments:
3.i) the three-dimensionally printed structure (1831, 1832, 1833, 2252) is formed inside and/or on a surface of the carrier body (101, 301);
3.ii) the three-dimensionally printed structure (1831, 1832, 1833, 2252) is formed along a stacking direction (R) of the plurality of layer structures;
3.iii) the three-dimensionally printed structure (1831, 1832, 1833, 2252) is formed perpendicular to a stacking direction (R) of the plurality of layer structures;
wherein in embodiment 3.iii) preferably the three-dimensionally printed structure (1831, 1832, 1833, 2252) has different cross-sectional areas, further in particular in a stacking direction (R) of the plurality of layer structures and/or perpendicular to a stacking direction (R) of the plurality of layer structures.

4. The component carrier (100, 300) according to one of the preceding claims, wherein the component carrier comprises a surrounding component carrier region and a surrounded component carrier region which is surrounded by the surrounding component carrier region, wherein in particular at least a part of the surrounding component carrier region and/or of the surrounded component carrier region can be configured as a further three-dimensionally printed structure (2253).

5. The component carrier (100, 300) according to one of the preceding claims, wherein the three-dimensionally printed structure (1831, 1832, 1833, 2252) is configured according to one of the following embodiments:
5.i) the three-dimensionally printed structure (1831, 1832, 1833, 2252) at least partially forms the electrically conductive layer structures (104) and/or electrically insulating layer structures (103);
5.ii) the three-dimensionally printed structure (1831, 1832, 1833, 2252) is configured as a rigid and/or flexible structure.

6. The component carrier (100, 300) according to one of the preceding claims, wherein the component carrier (100, 300) is configured according to one of the following embodiments:
6.i) the carrier body (101, 301) has a recess (330, 1626), wherein the three-dimensionally printed structure (1831, 1832, 1833, 2252) is printed within the recess (330, 1626);
6.ii) at least a part of the carrier body (101, 301) is at least partially encapsulated by means of the three-dimensionally printed structure (1831, 1832, 1833, 2252) as an encapsulant (207), wherein the encapsulant (207) is a steel and/or titanium encapsulant.

7. The component carrier (100, 300) according to one of the preceding claims, wherein the three-dimensionally printed structure (1831, 1832, 1833, 2252) is configured according to one of the following embodiments:
7.i) the three-dimensionally printed structure (1831, 1832, 1833, 2252) is at least partially configured as an electrically conductive connecting element (106), in particular as a connection pad (410), a pin (408), a socket, a micropin, an, in particular annular, sliding contact (612), and/or a spring contact;
wherein in embodiment 7i) preferably a solder deposit (511) can be applied to the conductive connecting element (106), in particular as a three-dimensionally printed structure (1831, 1832, 1833, 2252);
7.ii) the three-dimensionally printed structure (1831, 1832, 1833, 2252) is configured as a damping element, in particular as a spring (1417a, 1417b);
7.iii) the three-dimensionally printed structure (1831, 1832, 1833, 2252) is configured as a mechanical connecting element (106), in particular a threaded socket (106), a snap connection (1523), a hook and loop connection (1522, 1523), a zipper connection (1521), a guide rail, and/or a guide pin (1524);
wherein in embodiment 7.iii) preferably the mechanical connecting element (106) is configured to form a releasable connection;
7.iv) the three-dimensionally printed structure (1831, 1832, 1833, 2252) is a thermally conductive structure (1629);
7.v) the three-dimensionally printed structure (1831, 1832, 1833, 2252) comprises at least one material component selected from the group consisting of copper, aluminum, steel, titanium, metal alloy, plastic, and photoresist;
7.vi) the three-dimensionally printed structure (1831, 1832, 1833, 2252) is an antenna structure (1942),
wherein in embodiment 7.vi) preferably the antenna structure (1942) is configured such that the antenna structure (1942) can be printed directly onto and/or into the carrier body (101, 301);
7.vii) the three-dimensionally printed structure (1831, 1832, 1833, 2252) forms a reinforcement structure, in particular a reinforcement structure (1625) of the electrically conductive layer structures (104) and/or electrically insulating layer structures (103);
7.viii) the three-dimensionally printed structure (1831, 1832, 1833, 2252) forms a surface of the carrier body (101, 301), wherein regions of the surface differ in their hardness, roughness and/or elasticity;
wherein in embodiment 7.ii) preferably at least one region of the three-dimensionally printed structure (1831, 1832, 1833, 2252) is formed from steel and/or titanium;
and/or wherein in embodiment 7.ii) preferably the three-dimensionally printed structure (1831, 1832, 1833, 2252) forms at least one part of a component.

8. The component carrier (100, 300) according to one of the preceding claims, wherein the component carrier (100, 300) is configured according to one of the following embodiments:
8.i) the component carrier (100, 300) further comprises a component, in particular an electronic component, surface-mounted to and/or embedded in at least one of the plurality of electrically conductive layer structures (104) and/or electrically insulating layer structures (103);
wherein preferably in embodiment 8.i) the component is selected from a group consisting of an electronic component, an electrically non-conductive and/or electrically conductive inlay, a heat transfer unit, a light guiding element, an energy harvesting unit, an active electronic component, a passive electronic component, an electronic chip, a data storage device, a filter, an integrated circuit, a signal processing component, a power management component, an optoelectric converter, a voltage converter, a cryptographic component, a transmitting and/or receiving unit, an electromechanical converter, an actuator, a microelectromechanical system, a microprocessor, a capacitance, a resistor, an inductance, an accumulator, a switch, a camera, an antenna (1942), a magnetic element, a further component carrier (100, 300), and a logic chip;
8.ii) the three-dimensionally printed structure (1831, 1832, 1833, 2252) is configured such that a further three-dimensionally printed structure (2253) can be printed thereon;
8.iii) a further part of the component carrier (100, 300) is configured as a further three-dimensionally printed structure (2253), wherein the three-dimensionally printed structure (1831, 1832, 1833, 2252) and the further three-dimensionally printed structure (2253) consist of different materials;
wherein preferably in embodiment 8.iii):
8.iii.1) the one three-dimensionally printed structure (1831, 1832, 1833, 2252) comprises a higher thermal conductivity (1629) and/or current conductivity than the further three-dimensionally printed structure (2253), or
8.iii.2) the three-dimensionally printed structure (1831, 1832, 1833, 2252) and/or the further three-dimensionally printed structure (2253) is configured from an electrically conductive material, in particular aluminum, and/or wherein preferably in embodiment 8.iii) the three-dimensionally
printed structure (1831, 1832, 1833, 2252) and the further three-dimensionally printed structure (2253) are configured one above the other for forming a bimetallic element.

9. The component carrier (100, 300) according to one of the preceding claims, wherein the three-dimensionally printed structure (1831, 1832, 1833, 2252) is configured according to one of the following embodiments:
9.i) the three-dimensionally printed structure (1831, 1832, 1833, 2252) is configured as at least one of a group consisting of an active or passive electronic component, a resistor, a capacitor, a coil, an electrical contact (409, 2471), an anti-break, a USB contact, and a QFN contact;
9.ii) the three-dimensionally printed structure (1831, 1832, 1833, 2252) is configured as at least one of a group consisting of a sensor, an actuator, a magnetic sensor, EMC shielding, and a microelectromechanical system;
9.iii) the three-dimensionally printed structure (1831, 1832, 1833, 2252) is configured as at least one element selected from the group consisting of an optical element, a light detector, a light emitter, a lens (2360), a microlens, a waveguide (2680);
9.iv) the three-dimensionally printed structure (1831, 1832, 1833, 2252) is configured as at least one element selected from the group consisting of a microphone, a speaker, and a Helmholtz horn.

10. The component carrier (100, 300) according to one of the preceding claims, wherein the component carrier (100, 300) is configured according to one of the following embodiments:
10.i) at least one of the plurality of electrically conductive layer structures (104) comprises at least one of the group consisting of copper, aluminum, nickel, silver, gold, palladium, and tungsten, wherein one of said materials is optionally coated with highly conductive material such as graphene; and/or
10.ii) at least one of the plurality of electrically insulating layer structures (103) comprises at least one of the group consisting of resin, in particular reinforced or non-reinforced resin, for example epoxy resin or bismaleimide-triazine resin, FR-4, FR-5, cyanate ester, polyphenylene derivatives, glass, prepreg material, polyimide, polyamide, liquid crystalline polymer, epoxy-based construction film, polytetrafluoroethylene, a ceramic, and a metal oxide;
10.iii) the component carrier (100, 300) is formed as a board;
10.iv) the component carrier (100, 300) is configured as one of the group consisting of a printed circuit board and a substrate;
10.v) the component carrier (100, 300) is configured as a laminate type component carrier (100, 300).

11. The component carrier (100, 300) according to claim 1, wherein
the three-dimensionally printed structure (1831, 1832, 1833, 2252) is at least partially configured as an electrically conductive connecting element (106), in particular as a connection pad (410), a pin (408), or a micropin; and
a solder deposit (511) is applied to the conductive connecting element (106) as a further three-dimensionally printed structure (1831, 1832, 1833, 2252).

12. The component carrier (100, 300) according to claim 1, wherein the at least one of the plurality of electrically conductive layer structures (104) comprising at least one of the group consisting of aluminum, nickel, silver, gold, palladium, and tungsten is a further three-dimensionally printed structure (1116).

13. A method for producing a component carrier (100, 300) according to one of the preceding claims, wherein the method comprises:
connecting a plurality of electrically conductive layer structures (104) and/or electrically insulating layer structures (103) to form a carrier body (101, 301);
forming at least one part of the component carrier (100, 300) as a three-dimensionally printed structure (1831, 1832, 1833, 2252) by means of three-dimensionally printing;
wherein the three-dimensionally printed structure (1831, 1832, 1833, 2252) is formed by at least one of a group consisting of selective laser melting, selective laser sintering, and electron beam melting.

14. The method according to claim 13, wherein the three-dimensionally printing comprises:
introducing a printable material into a processing device,
melting the printable material in the processing device,
feeding the melted printable material onto and/or into the carrier body (101, 301) for forming at least one layer of at least a part of the three-dimensionally printed structure (1831, 1832, 1833, 2252); and/or
applying a printable material, in particular a powdery material, onto and/or into the carrier body (101, 301),
solidifying the applied printable material for forming at least one layer of at least a part of the three-dimensionally printed structure (1831, 1832, 1833, 2252);
wherein further preferably one of the following embodiments is implemented:
14.i) before the solidifying of the printable material, the printable material is melted by means of a thermal treatment device, in particular a laser device, and/or
14.ii) the printable material is applied by means of a material feed nozzle,
wherein in the embodiment 14.ii) more preferably the method further comprises
moving the material feed nozzle for forming a further layer of the at least one part of the three-dimensionally printed structure (1831, 1832, 1833, 2252);
or 14.iii) the carrier body (101, 301) is provided in a material bed before the printable material is fed to the carrier body (101, 301);
wherein in the embodiments 14.i) to 14.iii) more preferably the method further comprises
moving the carrier body (101, 301) for forming a further layer of the at least one part of the three-dimensionally printed structure.

15. The method according to claim 13,
wherein the method comprises arranging the carrier body (101, 301) in a container,
wherein the three-dimensionally printing comprises:
providing a solidifiable fluid material in the container,
solidifying the fluid material by means of a treatment device, in particular a laser device, onto and/or in the carrier body (101, 301) for forming at least one layer of at least a part of the three-dimensionally printed structure (1831, 1832, 1833, 2252);
wherein in particular the method further comprises
moving the carrier body (101, 301) for forming a further layer of the at least one part of the three-dimensionally printed structure (1831, 1832, 1833, 2252).

## Revendications

1. Support de composants (100, 300), dans lequel le support de composants (100, 300) présente :
un corps de support (101, 301), présentant une pluralité de structures stratifiées électriquement conductrices (104) et/ou de structures stratifiées électriquement isolantes (103) ;
dans lequel au moins une partie du support de composants (100, 300) est réalisée sous forme de structure imprimée en trois dimensions (1831, 1832, 1833, 2252), **caractérisé en ce que**
au moins une parmi la pluralité des structures stratifiées électriquement conductrices (104) comprend au moins un matériau issu du groupe constitué de l'aluminium, du nickel, de l'argent, de l'or, du palladium et du tungstène ;
la structure imprimée en trois dimensions (1831, 1832, 1833, 2252) comprend du cuivre et est imprimée sur la au moins une parmi la pluralité de structures stratifiées électriquement conductrices (104) qui comprend au moins un matériau issu du groupe constitué de l'aluminium, du nickel, de l'argent, de l'or, du palladium et du tungstène ; et
la structure imprimée en trois dimensions (1831, 1832, 1833, 2252) est formée au moyen d'au moins un procédé issu d'un groupe constitué de la fusion sélective par laser, du frittage sélectif par laser et de la fusion par faisceau d'électrons.

2. Support de composants (100, 300) selon la revendication 1, dans lequel la structure imprimée en trois dimensions (1831, 1832, 1833, 2252) est une parmi celles ci-dessous :
une fiche, une microfiche, une douille, un contact glissant annulaire, une douille filetée, une liaison par velcro, une liaison par fermeture à glissière, un bilame, une sécurité anti-rupture, un contact USB, un contact QFN, un capteur magnétique, une lentille, une microlentille, un guide d'ondes, une unité de fourniture d'énergie, un convertisseur optoélectrique, un convertisseur de tension, un composant cryptographique, un accumulateur ou une caméra.

3. Support de composants (100, 300) selon l'une quelconque des revendications précédentes, dans lequel la structure imprimée en trois dimensions (1831, 1832, 1833, 2252) est réalisée selon l'un des modes de réalisation ci-dessous :
3.i) la structure imprimée en trois dimensions (1831, 1832, 1833, 2252) est formée à l'intérieur et/ou sur une surface du corps de support (101, 301) ;
3.ii) la structure imprimée en trois dimensions (1831, 1832, 1833, 2252) est formée le long d'une direction d'empilement (R) de la pluralité de structures stratifiées ;
3.iii) la structure imprimée en trois dimensions (1831, 1832, 1833, 2252) est formée perpendiculairement à une direction d'empilement (R) de la pluralité de structures stratifiées ;
dans lequel, dans le mode de réalisation 3.iii), la structure imprimée en trois dimensions (1831, 1832, 1833, 2252) présente de manière préférée des surfaces en coupe transversale différentes, en particulier dans une direction d'empilement (R) de la pluralité de structures stratifiées et/ou perpendiculairement à une direction d'empilement (R) de la pluralité de structures stratifiées.

4. Support de composants (100, 300) selon l'une quelconque des revendications précédentes, dans lequel le support de composants présente une région de support de composants entourante et une région de support de composants entourée qui est entourée par la région de support de composants entourante, dans lequel en particulier au moins une partie de la région de support de composants entourante et/ou de la région de support de composants entourée peut être réalisée sous forme de structure imprimée en trois dimensions (2253) supplémentaire.

5. Support de composants (100, 300) selon l'une quelconque des revendications précédentes, dans lequel la structure imprimée en trois dimensions (1831, 1832, 1833, 2252) est réalisée selon l'un des modes de réalisation ci-dessous :
5.i) la structure imprimée en trois dimensions (1831, 1832, 1833, 2252) forme au moins partiellement les structures stratifiées électriquement conductrices (104) et/ou les structures stratifiées électriquement isolantes (103) ;
5.ii) la structure imprimée en trois dimensions (1831, 1832, 1833, 2252) est réalisée sous la forme d'une structure rigide et/ou flexible.

6. Support de composants (100, 300) selon l'une quelconque des revendications précédentes, dans lequel le support de composants (100, 300) est réalisé selon l'un des modes de réalisation ci-dessous :
6.i) le corps de support (101, 301) présente un évidement (330, 1626), dans lequel la structure imprimée en trois dimensions (1831, 1832, 1833, 2252) est imprimée à l'intérieur de l'évidement (330, 1626) ;
6.ii) au moins une partie du corps de support (101, 301) est au moins partiellement encapsulée sous la forme d'une encapsulation (207) au moyen de la structure imprimée en trois dimensions (1831, 1832, 1833, 2252), dans lequel l'encapsulation (207) est une encapsulation en acier et/ou en titane.

7. Support de composants (100, 300) selon l'une quelconque des revendications précédentes, dans lequel la structure imprimée en trois dimensions (1831, 1832, 1833, 2252) est réalisée selon l'un des modes de réalisation ci-dessous :
7.i) la structure imprimée en trois dimensions (1831, 1832, 1833, 2252) est réalisée au moins partiellement sous forme d'élément de connexion (106) électriquement conducteur, en particulier sous la forme d'un plot de raccordement (410), d'une fiche (408), d'une douille, d'une microfiche, d'un contact glissant (612), en particulier annulaire, et/ou d'un contact à ressort ;
dans lequel, dans le mode de réalisation 7i), un dépôt de soudure (511) peut être appliqué de manière préférée sur l'élément de connexion (106) conducteur, en particulier sous forme de structure imprimée en trois dimensions (1831, 1832, 1833, 2252) ;
7.ii) la structure imprimée en trois dimensions (1831, 1832, 1833, 2252) est réalisée sous la forme d'un élément d'amortissement, en particulier sous la forme d'un ressort (1417a, 1417b) ;
7.iii) la structure imprimée en trois dimensions (1831, 1832, 1833, 2252) est réalisée sous la forme d'un élément de connexion (106) mécanique, en particulier d'une douille filetée (106), d'une liaison à encliquetage (1523), d'une liaison par velcro (1522, 1523), d'une liaison par fermeture à glissière (1521), d'un rail de guidage et/ou d'une broche de guidage (1524) ;
dans lequel, dans le mode de réalisation 7.iii), l'élément de connexion (106) mécanique est de manière préférée conçu pour former une liaison amovible ;
7.iv) la structure imprimée en trois dimensions (1831, 1832, 1833, 2252) est une structure thermoconductrice (1629) ;
7.v) la structure imprimée en trois dimensions (1831, 1832, 1833, 2252) présente au moins un composant de matériau choisi dans le groupe constitué du cuivre, de l'aluminium, de l'acier, du titane, d'un alliage métallique, du plastique et d'une résine photosensible ;
7.vi) la structure imprimée en trois dimensions (1831, 1832, 1833, 2252) est une structure d'antenne (1942) ;
dans lequel, dans le mode de réalisation 7.vi), la structure d'antenne (1942) est de manière préférée réalisée de telle manière que la structure d'antenne (1942) peut être imprimée directement sur et/ou dans le corps de support (101, 301) ;
7.vii) la structure imprimée en trois dimensions (1831, 1832, 1833, 2252) forme une structure de renforcement, en particulier une structure de renforcement (1625) des structures stratifiées électriquement conductrices (104) et/ou des structures stratifiées électriquement isolantes (103) ;
7.viii) la structure imprimée en trois dimensions (1831, 1832, 1833, 2252) forme une surface du corps de support (101, 301), dans lequel des régions de la surface se différencient par leur dureté, leur rugosité et/ou leur élasticité ;
dans lequel, dans le mode de réalisation 7.ii), au moins une région de la structure imprimée en trois dimensions (1831, 1832, 1833, 2252) est réalisée de manière préférée en acier et/ou en titane ;
et/ou dans lequel, dans le mode de réalisation 7.ii), la structure imprimée en trois dimensions (1831, 1832, 1833, 2252) forme de manière préférée au moins une partie d'un composant.

8. Support de composants (100, 300) selon l'une quelconque des revendications précédentes, dans lequel le support de composants (100, 300) est réalisé selon l'un des modes de réalisation ci-dessous :
8.i) le support de composants (100, 300) présente en outre un composant, en particulier un composant électronique, monté en surface sur, et/ou intégré dans, au moins une parmi la pluralité de structures stratifiées électriquement conductrices (104) et/ou de structures stratifiées électriquement isolantes (103) ;
dans lequel, dans le mode de réalisation 8.i), le composant est choisi dans un groupe constitué d'un composant électronique, d'un insert électriquement non conducteur et/ou électriquement conducteur, d'une unité de transfert de chaleur, d'un élément de guidage de lumière, d'une unité de fourniture d'énergie, d'un composant électronique actif, d'un composant électronique passif, d'une puce électronique, d'un dispositif de stockage de données, d'un filtre, d'un circuit intégré, d'un composant de traitement du signal, d'un composant de gestion de puissance, d'un convertisseur optoélectrique, d'un convertisseur de tension, d'un composant cryptographique, d'une unité d'émission et/ou de réception, d'un convertisseur électromécanique, d'un actionneur, d'un système microélectromécanique, d'un microprocesseur, d'une capacité, d'une résistance, d'une inductance, d'un accumulateur, d'un commutateur, d'une caméra, d'une antenne (1942), d'un élément magnétique, d'un support de composants (100, 300) supplémentaire et d'une puce logique ;
8.ii) la structure imprimée en trois dimensions (1831, 1832, 1833, 2252) est réalisée de telle manière qu'il est possible d'imprimer dessus une structure imprimée en trois dimensions (2253) supplémentaire ;
8.iii) une autre partie du support de composants (100, 300) est réalisée sous forme de structure imprimée en trois dimensions (2253) supplémentaire, dans lequel la structure imprimée en trois dimensions (1831, 1832, 1833, 2252) et la structure imprimée en trois dimensions (2253) supplémentaire sont constituées de matériaux différents ;
dans lequel, de manière préférée dans le mode de réalisation 8.iii) :
8.iii.1) la structure imprimée en trois dimensions (1831, 1832, 1833, 2252) présente une conductivité thermique (1629) et/ou une conductivité électrique supérieure(s) à celle(s) de la structure imprimée en trois dimensions (2253) supplémentaire, ou
8.iii.2) la structure imprimée en trois dimensions (1831, 1832, 1833, 2252) et/ou la structure imprimée en trois dimensions (2253) supplémentaire est réalisée à partir d'un matériau électriquement conducteur, en particulier en aluminium,
et/ou dans lequel, de manière préférée dans le mode de réalisation 8.iii), la structure imprimée en trois dimensions (1831, 1832, 1833, 2252) et la structure imprimée en trois dimensions (2253) supplémentaire sont réalisées l'une au-dessus de l'autre afin de former un élément bimétallique.

9. Support de composants (100, 300) selon l'une quelconque des revendications précédentes, dans lequel la structure imprimée en trois dimensions (1831, 1832, 1833, 2252) est réalisée selon l'un des modes de réalisation ci-dessous :
9.i) la structure imprimée en trois dimensions (1831, 1832, 1833, 2252) est réalisée sous la forme d'au moins un élément issu d'un groupe constitué d'un composant électronique actif ou passif, d'une résistance, d'un condensateur, d'une bobine, d'un contact électrique (409, 2471), d'une sécurité anti-rupture, d'un contact USB et d'un contact QFN ;
9.ii) la structure imprimée en trois dimensions (1831, 1832, 1833, 2252) est réalisée sous la forme d'au moins un élément issu d'un groupe constitué d'un capteur, d'un actionneur, d'un capteur magnétique, d'un blindage CEM et d'un système microélectromécanique ;
9.iii) la structure imprimée en trois dimensions (1831, 1832, 1833, 2252) est réalisée sous la forme d'au moins un élément choisi dans le groupe constitué d'un élément optique, d'un détecteur de lumière, d'un émetteur de lumière, d'une lentille (2360), d'une microlentille, d'un guide d'ondes (2680) ;
9.iv) la structure imprimée en trois dimensions (1831, 1832, 1833, 2252) est réalisée sous la forme d'au moins un élément choisi dans le groupe constitué d'un microphone, d'un haut-parleur et d'un résonateur de Helmholtz.

10. Support de composants (100, 300) selon l'une quelconque des revendications précédentes, dans lequel le support de composants (100, 300) est réalisé selon l'un des modes de réalisation ci-dessous :
10.i) au moins une parmi la pluralité de structures stratifiées électriquement conductrices (104) présente au moins un matériau issu du groupe constitué du cuivre, de l'aluminium, du nickel, de l'argent, de l'or, du palladium et du tungstène, dans lequel un des matériaux mentionnés est éventuellement revêtu d'un matériau hautement conducteur tel que du graphène ; et/ou
10.ii) au moins une parmi la pluralité de structures stratifiées électriquement isolantes (103) présente au moins un matériau issu du groupe constitué d'une résine, en particulier une résine renforcée ou non renforcée, par exemple une résine époxy ou une résine bismaléimide-triazine, du FR-4, du FR-5, de l'ester de cyanate, des dérivés de polyphénylène, du verre, d'un matériau préimprégné, d'un polyimide, d'un polyamide, d'un polymère à cristaux liquides, d'un film de construction à base d'époxy, du polytétrafluoroéthylène, d'une céramique et d'un oxyde métallique ;
10.iii) le support de composants (100, 300) est réalisé sous la forme d'une plaque ;
10.iv) le support de composants (100, 300) est configuré comme un élément du groupe constitué d'une carte de circuit imprimé et d'un substrat ;
10.v) le support de composants (100, 300) est configuré comme un support de composants (100, 300) de type stratifié.

11. Support de composants (100, 300) selon la revendication 1, dans lequel
la structure imprimée en trois dimensions (1831, 1832, 1833, 2252) est réalisée au moins partiellement sous forme d'élément de connexion (106) électriquement conducteur, en particulier sous la forme d'un plot de raccordement (410), d'une fiche (408) ou d'une microfiche ; et
un dépôt de soudure (511) est appliqué sur l'élément de connexion (106) conducteur en tant que structure imprimée en trois dimensions (1831, 1832, 1833, 2252) supplémentaire.

12. Support de composants (100, 300) selon la revendication 1, dans lequel au moins une parmi la pluralité de structures stratifiées électriquement conductrices (104), qui comprend au moins un matériau issu du groupe constitué de l'aluminium, du nickel, de l'argent, de l'or, du palladium et du tungstène, est une structure imprimée en trois dimensions (1116) supplémentaire.

13. Procédé de fabrication d'un support de composants (100, 300) selon l'une quelconque des revendications précédentes, dans lequel le procédé comprend les étapes consistant à :
connecter une pluralité de structures stratifiées électriquement conductrices (104) et/ou de structures stratifiées électriquement isolantes (103) afin de former un corps de support (101, 301) ;
réaliser au moins une partie du support de composants (100, 300) sous forme de structure imprimée en trois dimensions (1831, 1832, 1833, 2252) au moyen d'une impression en trois dimensions ;
dans lequel la structure imprimée en trois dimensions (1831, 1832, 1833, 2252) est formée au moyen d'au moins un procédé issu d'un groupe constitué de la fusion sélective par laser, du frittage sélectif par laser et de la fusion par faisceau d'électrons.

14. Procédé selon la revendication 13, dans lequel l'impression en trois dimensions comprend les étapes consistant à :
introduire un matériau imprimable dans un dispositif de traitement,
faire fondre le matériau imprimable dans le dispositif de traitement,
alimenter le matériau imprimable fondu sur et/ou dans le corps de support (101, 301) afin de former au moins une couche d'au moins une partie de la structure imprimée en trois dimensions (1831, 1832, 1833, 2252) ; et/ou
appliquer une matériau imprimable, en particulier un matériau sous forme de poudre, sur et/ou dans le corps de support (101, 301),
solidifier le matériau imprimable appliqué afin de former au moins une couche d'au moins une partie de la structure imprimée en trois dimensions (1831, 1832, 1833, 2252) ;
dans lequel de manière préférée un des modes de réalisation ci-dessous est mis en œuvre :
14.i) le matériau imprimable est fondu au moyen d'un dispositif de traitement thermique, en particulier d'un dispositif laser, avant la solidification du matériau imprimable, et/ou
14.ii) le matériau imprimable est appliqué au moyen d'une buse d'alimentation en matériau,
dans lequel, dans le mode de réalisation 14.ii), le procédé comprend en outre de manière plus préférée les étapes consistant à :
déplacer la buse d'alimentation en matériau afin de former une couche supplémentaire de la au moins une partie de la structure imprimée en trois dimensions (1831, 1832, 1833, 2252) ;
ou 14.iii) le corps de support (101, 301) est fourni dans un lit de matériau avant que le matériau imprimable ne soit alimenté vers le corps de support (101, 301) ;
dans lequel, dans les modes de réalisation 14.i) à 14.iii), le procédé comprend en outre de manière plus préférée les étapes consistant à :
déplacer le corps de support (101, 301) afin de former une couche supplémentaire de la au moins une partie de la structure imprimée en trois dimensions.

15. Procédé selon la revendication 13,
dans lequel le procédé comprend une étape consistant à agencer le corps de support (101, 301) dans un récipient,
dans lequel l'impression en trois dimensions comprend les étapes consistant à :
fournir un matériau fluide, pouvant être solidifié, dans le récipient,
solidifier le matériau fluide au moyen d'un dispositif de traitement, en particulier d'un dispositif laser, sur et/ou dans le corps de support (101, 301) afin de former au moins une couche d'au moins une partie de la structure imprimée en trois dimensions (1831, 1832, 1833, 2252) ;
dans lequel le procédé comprend en outre les étapes consistant à :
déplacer le corps de support (101, 301) afin de former une couche supplémentaire de la au moins une partie de la structure imprimée en trois dimensions (1831, 1832, 1833, 2252).
